# FASCICULE DE BREVET EUROPEEN

(11) **EP 1 342 244 B1**
(45) Date de publication et mention de la délivrance du brevet: **06.04.2005**
(21) Numéro de dépôt: 01996861.9
(22) Date de dépôt: 14.11.2001
(51) Int. Cl.: G11C 16/16, G11C 16/34

(54) **MEMOIRE FLASH EFFACABLE PAR PAGE**
SEITENLÖSCHBARER FLASH-SPEICHER
PAGE-ERASABLE FLASH MEMORY

(30) Priorité: 15.11.2000 FR 0014743
(43) Date de publication de la demande: 10.09.2003
(73) Titulaire: STMicroelectronics S.A., 92120 Montrouge (FR)
(72) Inventeur: CAVALERI, Paola, 13790 Rousset (FR); LECONTE, Bruno, F-13790 Rousset (FR); ZINK, Sébastien, F-13090 Aix en Provence (FR); DEVIN, Jean, F-13100 le Tholonet (FR)
(74) Mandataire: Marchand, André
(86) Numéro de dépôt international: PCT/FR2001/003560
(87) Numéro de publication internationale: WO 2002/041322

(56) Documents cités:
- US-A- 5 239 505
- US-A- 5 598 368
- US-A- 5 994 732
- US-A- 6 021 083
- SHIGERU ATSUMI ET AL: "A 16-MB FLASH EEPROM WITH A NEW SELF-DATA-REFRESH SCHEME FOR A SECTOR ERASE OPERATION" IEICE TRANSACTIONS ON ELECTRONICS,JP,INSTITUTE OF ELECTRONICS INFORMATION AND COMM. ENG. TOKYO, vol. E77-C, no. 5, 1 mai 1994 (1994-05-01), pages 791-798, XP000459519 ISSN: 0916-8524

## Description

La présente invention concerne les mémoires effaçables et programmables électriquement, et plus particulièrement les mémoires FLASH.

La présente invention concerne plus particulièrement les mémoires FLASH effaçables par page.

A l'heure actuelle, le marché des mémoires en circuits intégrés effaçables et programmables électriquement comprend essentiellement les mémoires EEPROM et les mémoires FLASH (ou FLASH-EEPROM) . Les mémoires EEPROM peuvent être programmable et effaçable par mot ou programmable et effaçable par page. Pour des raisons technologiques, les mémoires FLASH (ou FLASH-EEPROM) sont généralement programmables par mot et effaçables par secteur, un secteur comprenant généralement un grand nombre de pages.

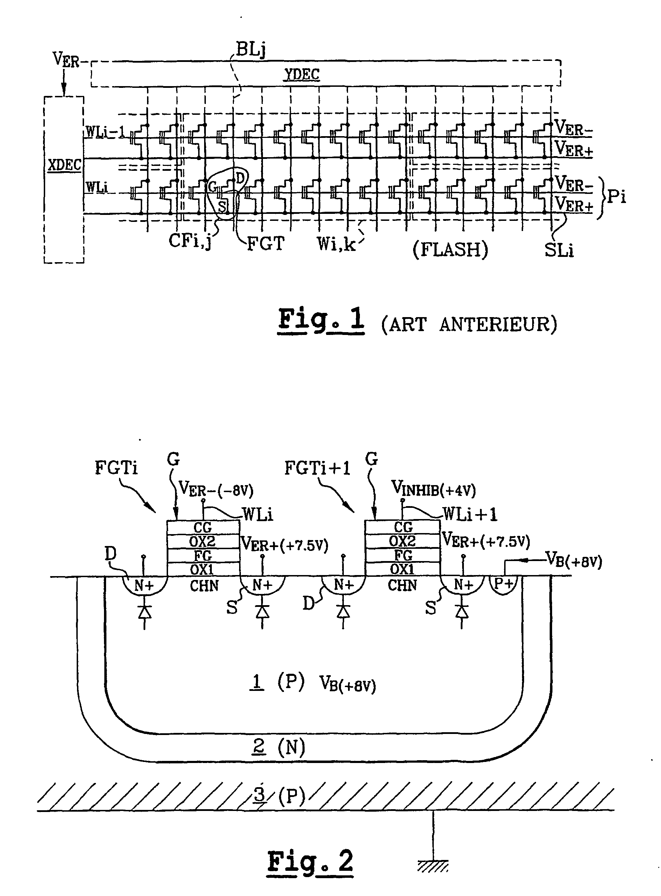

A titre de rappel, la figure 1 représente schématiquement un plan mémoire FLASH comprenant une pluralité de cellules mémoire CF_{i,j} agencées de façon matricielle et connectées à des lignes de mot WLᵢ et des lignes de bit BLⱼ . Les cellules CF_{i,j} de la mémoire FLASH sont d'une structure très simple et ne comportent qu'un transistor à grille flottante FGT, ici un transistor NMOS, ayant sa grille G connectée à une ligne de mot WLᵢ, son drain D connecté à une ligne de bit BLⱼ et sa source S connectée à une ligne de source SLᵢ. Les lignes de bit BLⱼ sont regroupées par colonnes de rang k pour former des mots binaires W_{i,k} comportant par exemple huit cellules CF_{i,j} chacun (octets) , les cellules d'un même mot W_{i,k} pouvant être adjacentes (comme représenté en figure 1) ou entrelacées avec des cellules appartenant à d'autres mots. Une page physique Pᵢ de la mémoire FLASH est formée par l'ensemble des cellules mémoire C_{i,j} connectées à une même ligne de mot WLᵢ, et comprend ainsi une pluralité de mots binaires W_{i,k}. Un secteur est formé par un ensemble de pages Pᵢ dont les lignes de source SLᵢ sont interconnectées et se trouvent toujours au même potentiel électrique.

Dans une telle mémoire FLASH, la programmation d'une cellule consiste dans l'injection de charges électriques dans la grille flottante par effet dit "d'injection d'électrons chauds" ("hot electron injection") tandis que l'effacement d'une cellule consiste dans l'extraction, par effet tunnel, des charges électriques piégées dans la grille flottante. Un transistor FGT effacé présente une tension de seuil positive VT1 de faible valeur et un transistor programmé présente une tension de seuil VT2 supérieure à VT1. Lorsqu'une tension de lecture V_{READ} comprise entre VT1 et VT2 est appliquée sur sa grille, un transistor effacé est passant, ce qui correspond par convention à la lecture d'un "1" logique, et un transistor programmé reste bloqué, ce qui correspond par convention à la lecture d'un "0" logique.

En raison de la simplicité de leurs cellules mémoire, qui ne comporte pas de transistor d'accès comme dans les mémoires EEPROM, les mémoires FLASH présentent l'avantage d'une grande compacité en termes de surface de silicium occupée et présentent ainsi, à surface de silicium constante, une capacité de stockage nettement supérieure à celle des mémoires EEPROM, pour un prix de revient inférieur. En revanche, elles sont moins souples à l'emploi en raison de la nécessité d'effacer simultanément toutes les cellules mémoire d'un même secteur.

Dans certaines applications, on souhaite toutefois bénéficier des avantages des mémoires FLASH (compacité et prix de revient) tout en bénéficiant de la possibilité d'un effacement par page, par exemple lorsque les données à enregistrer sont d'un faible volume et que l'effacement de tout un secteur avant la programmation d'une page n'est pas envisageable. Toutefois, la recherche d'une mémoire FLASH effaçable par page se heurte à certaines difficultés.

Pour comprendre le problème posé, rappelons préalablement que l'effacement d'une cellule mémoire peut être effectué selon la méthode dite d'effacement par la source ("source erase") ou la méthode dite d'effacement par le canal ("channel erase") .

L'effacement par la source, illustré en figure 1, consiste à appliquer à l'ensemble des lignes de source SLᵢ d'un même secteur une tension d'effacement positive V_{ER+} de l'ordre de 4 à 5V, tandis que les lignes de mot WLᵢ du secteur considéré reçoivent une tension d'effacement négative V_{ER-} de l'ordre de -8V, le matériau formant le canal des transistors (substrat ou caisson) étant à la masse. La différence de potentiel apparaissant entre la source S et la grille G des transistors a pour effet d'arracher les charges électriques piégées dans les grilles flottantes (par effet tunnel) et d'effacer les transistors. L'application de la tension négative V_{ER-} sur les grilles de tous les transistors d'un même secteur est assurée par l'inhibition d'un décodeur de ligne de mot XDEC (figure 1) , qui reçoit la tension V_{ER-} sur une entrée et l'applique à toutes les lignes de mot WLᵢ du secteur à effacer quelle que soit l'adresse reçue en entrée. Simultanément, toutes les sorties d'un décodeur de colonne YDEC connectées aux lignes de bit BLⱼ sont portées à haute impédance.

L'effacement par le canal se distingue de l'effacement par la source par le fait que la tension d'effacement positive V_{ER+} est appliquée aux sources des transistors par l'intermédiaire du matériau formant les régions de canal (substrat ou caisson) auquel on applique une tension de polarisation V_{B}. Les jonctions PN existant entre les régions de canal et les régions de source se trouvent polarisées dans le sens passant et la tension V_{B} se répercute sur toutes les sources des transistors d'un même secteur pour former la tension V_{ER+}. Parallèlement, la tension d'effacement négative V_{ER-} est, comme précédemment, appliquée aux grilles des transistors par l'intermédiaire du décodeur de ligne de mot XDEC se trouvant dans l'état inhibé.

L'avantage d'un effacement par le canal est que les régions de canal et les régions de source se trouvent sensiblement au même potentiel électrique, les diodes de jonction canal/source étant polarisées dans le sens passant. Par rapport à un effacement par la source, il n'y a donc plus de courant de fuite dans le sens source/canal. La tension d'effacement V_{ER+} peut être portée à un potentiel plus élevé que dans le cas d'un effacement par la source, par exemple 8 à 10V contre 4 à 5V dans le premier cas.

Une solution connue pour réaliser une mémoire FLASH effaçable par page consiste à équiper chaque ligne de source SLᵢ d'un transistor de sélection permettant une application sélective de la tension d'effacement V_{ER+}. Une telle solution est dans l'esprit de l'enseignement divulgué par le brevet EP 704 851 et la demande WO 98/33187, dans lesquels l'effacement sélectif d'un mot est obtenu en équipant les cellules d'un même mot d'un transistor de sélection de source.

Cette solution présente toutefois divers inconvénients. D'une part, la programmation d'une cellule de mémoire FLASH s'effectue avec un courant drain-source non négligeable. De ce fait, en cas de programmation simultanée de toutes les cellules d'un mot, un courant important est collecté par le transistor de sélection de la ligne de source. Ce courant entraîne une élévation de la tension drain-source du transistor de sélection, une diminution correspondante de la tension drain-source des transistors à grille flottante, et une augmentation du temps de programmation. Les cellules d'un même mot doivent donc être programmées individuellement, ou conjointement à des cellules appartenant à d'autres mots binaires (WO 98/33187). D'autre part, la prévision de transistors de sélection de ligne de source n'est pas compatible avec la méthode d'effacement par le canal. En effet, la tension d'effacement V_{ER+} étant dans ce cas appliquée par l'intermédiaire du matériau formant le canal, la prévision de transistors de sélection de ligne de source n'empêche pas la tension V_{ER+} de parvenir aux sources de transistors et de créer un champ électrique entraînant l'arrachement des charges piégées dans les grilles flottantes.

Un procédé et une mémoire FLASH selon les préambules des revendications 1 et 13 est connu de US 5 598 368.

Ainsi, un objectif de la présente invention est de prévoir un procédé d'effacement sélectif d'une page de mémoire FLASH qui ne nécessite pas la prévision de transistors de sélection de ligne de source.

Un autre objectif de la présente invention est de prévoir un procédé d'effacement sélectif d'une page de mémoire FLASH qui soit compatible avec la méthode d'effacement par le canal.

Un autre objectif de la présente invention est de prévoir une mémoire FLASH programmable par page qui soit protégée contre une altération éventuelle de la tension de seuil de ses transistors à grille flottante, due notamment à la mise en oeuvre d'un procédé d'effacement sélectif par page selon l'invention.

A cet effet, la présente invention prévoit un procédé d'enregistrement de données dans une mémoire FLASH comprenant au moins un secteur, dans lequel l'effacement d'une page de la mémoire comprend l'application d'une tension d'effacement négative aux grilles des transistors à grille flottante de la page à effacer, l'application d'une tension d'effacement positive aux électrodes de source ou de drain de tous les transistors à grille flottante du secteur de la mémoire comprenant la page à effacer, et l'application d'une tension d'inhibition positive aux grilles des transistors d'au moins une page de la mémoire ne devant pas être effacée, le procédé comprenant une étape de contrôle d'au moins une page de la mémoire, comprenant une première lecture de la page faite en appliquant une première tension de lecture aux grilles des transistors de la page, une seconde lecture de la page faite en appliquant une deuxième tension de lecture différente de la première tension de lecture aux grilles des transistors de la page, et une reprogrammation de transistors si les deux lectures donnent des résultats différents.

Selon un mode de réalisation, la deuxième tension de lecture est supérieure à la première tension de lecture, la première tension de lecture correspond à une tension de lecture normale utilisée pendant des phases de lecture de la mémoire, et la reprogrammation de transistors est faite en utilisant comme données de reprogrammation les données lues en appliquant la première tension de lecture.

Selon un mode de réalisation, la tension d'inhibition est inférieure à la tension d'effacement positive.

Selon un mode de réalisation, le procédé comprend une étape consistant à prévoir dans la mémoire des circuits adaptateurs de tension recevant chacun en entrée un signal de sélection de page et délivrant aux grilles des transistors de la page correspondante : une tension positive, lorsque le signal de sélection de page présente une première valeur correspondant à la non-sélection de la page et que la mémoire est en mode effacement ou lorsque le signal de sélection présente une deuxième valeur correspondant à la sélection de la page et que la mémoire n'est pas en mode effacement, ou une tension de polarisation inférieure à la tension positive, lorsque le signal de sélection présente la deuxième valeur et que la mémoire est en mode effacement ou lorsque le signal de sélection présente la première valeur et que la mémoire n'est pas en mode effacement.

Selon un mode de réalisation, les circuits adaptateurs de tension reçoivent : pendant l'effacement d'une page, une tension de polarisation égale à la tension d'effacement négative et une tension positive égale à la tension d'inhibition, et pendant la lecture d'un mot dans la mémoire, une tension de polarisation égale au potentiel de masse et une tension positive égale à une tension de lecture.

Selon un mode de réalisation le procédé comprend, après chaque écriture d'une page dans un secteur de la mémoire, le contrôle de K pages du secteur considéré, K étant strictement inférieur au nombre de pages du secteur considéré et au moins égal à 1.

Selon un mode de réalisation, l'étape de contrôle est appliquée à au moins une page de la mémoire se trouvant à une adresse lue dans un compteur non volatile formé par au moins une rangée de transistors à grille flottante.

Selon un mode de réalisation, le compteur est incrémenté d'une unité après le contrôle d'au moins une page, en programmant au moins un transistor à grille flottante du compteur sans effacer les autres transistors du compteur, le transistor programmé à chaque nouvelle incrémentation du compteur étant le transistor suivant le transistor programmé à l'incrémentation précédente, selon un sens de lecture du compteur.

Selon un mode de réalisation, le compteur comprend une pluralité de mots de rang croissant, et la lecture dans le compteur de l'adresse d'au moins une page à contrôler comprend les étapes consistant à lire le compteur mot à mot jusqu'à trouver un mot comprenant un bit correspondant à un transistor effacé, déterminer les bits de poids fort de l'adresse de la page à contrôler au moyen du rang, dans le compteur, du premier mot trouvé comprenant un bit correspondant à un transistor effacé, et déterminer les bits de poids faible de l'adresse de la page à contrôler au moyen du rang, dans le premier mot trouvé, du premier bit correspondant à un transistor effacé.

Selon un mode de réalisation, les transistors à grille flottante du compteur sont agencés dans un secteur exclusivement dédié au compteur, de sorte que des tensions de programmation appliquées à des transistors à grille flottante d'un autre secteur de la mémoire ne se répercutent pas sur les transistors à grille flottante du compteur.

Selon un mode de réalisation, le contrôle d'une page est effectué mot à mot et le contrôle d'un mot comprend la lecture du mot avec la première tension de lecture, la lecture du mot avec la deuxième tension de lecture, et la reprogrammation de transistors si les deux lectures donnent des résultats différents.

Selon un mode de réalisation, la tension d'effacement positive est appliquée aux électrodes de source ou de drain des transistors à grille flottante par l'intermédiaire du matériau formant le canal des transistors.

La présente invention concerne également une mémoire FLASH effaçable par page comprenant un plan mémoire comportant une pluralité de pages comprenant chacune des transistors à grille flottante connectés par leurs grilles à des lignes de mot, un décodeur de ligne de mot connecté aux lignes de mot de la mémoire, des moyens pour appliquer une tension d'effacement positive aux électrodes de source ou de drain de tous les transistors à grille flottante d'un secteur comprenant une page à effacer, le décodeur de ligne de mot comprenant des moyens pour appliquer, lors de l'effacement d'une page, une tension d'effacement négative aux grilles des transistors de la page à effacer tout en appliquant une tension d'inhibition positive aux grilles des transistors d'au moins une page ne devant pas être effacée, la mémoire comprenant des moyens de contrôle d'au moins une page de la mémoire, agencés pour effectuer une première lecture de la page en appliquant une première tension de lecture aux grilles des transistors de la page, effectuer une seconde lecture de la page en appliquant une deuxième tension de lecture différente de la première tension de lecture, aux grilles des transistors de la page, et reprogrammer des transistors de la page si les deux lectures donnent des résultats différents.

Selon un mode de réalisation, la deuxième tension de lecture est supérieure à la première tension de lecture, la première tension de lecture correspond à une tension de lecture normale utilisée pendant des phases de lecture de la mémoire, et la reprogrammation de transistors est faite en utilisant comme données de reprogrammation les données lues en appliquant la première tension de lecture.

Selon un mode de réalisation, la tension d'inhibition délivrée par le décodeur de ligne de mot est inférieure à la tension d'effacement positive.

Selon un mode de réalisation, le décodeur de ligne de mot comprend des circuits adaptateurs de tension recevant en entrée un signal de sélection de page et délivrant aux grilles des transistors de la page correspondante : une tension positive, lorsque le signal de sélection présente une première valeur correspondant à la non-sélection de la page et que la mémoire est en mode effacement ou lorsque le signal de sélection présente une deuxième valeur correspondant à la sélection de la page et que la mémoire n'est pas en mode effacement, ou une tension de polarisation inférieure à la tension positive, lorsque le signal de sélection présente la deuxième valeur et que la mémoire est en mode effacement ou lorsque le signal de sélection présente la première valeur et que la mémoire n'est pas en mode effacement.

Selon un mode de réalisation, la mémoire comprend des moyens pour fournir aux circuits adaptateurs de tension : pendant l'effacement d'une page, une tension de polarisation égale à la tension d'effacement négative et une tension positive égale à la tension d'inhibition, et pendant la lecture d'un mot dans la mémoire, une tension de polarisation égale au potentiel de masse et une tension positive égale à une tension de lecture.

Selon un mode de réalisation, le circuit adaptateur de tension comprend un étage inverseur de sortie recevant d'une part la tension positive et d'autre part la tension de polarisation, et un étage de commande de l'étage inverseur comprenant une fonction logique OU EXCLUSIF recevant en entrée le signal de sélection et un signal présentant une valeur déterminée pendant l'effacement d'une page.

Selon un mode de réalisation, les moyens de contrôle sont agencés pour, après chaque écriture d'une page dans un secteur de la mémoire, contrôler K pages du secteur considéré, K étant strictement inférieur au nombre de pages du secteur considéré et au moins égal à 1.

Selon un mode de réalisation, les moyens de contrôle comprennent un compteur non volatile formé par au moins une rangée de transistors à grille flottante, des moyens pour lire dans le compteur l'adresse d'au moins une page à contrôler, et des moyens d'incrémentation du compteur après le contrôle d'au moins une page.

Selon un mode de réalisation, les moyens pour lire l'adresse d'au moins une page à contrôler comprennent des moyens de lecture mot à mot du compteur et de recherche d'un mot contenant un bit correspondant à un transistor effacé, des moyens pour délivrer des bits de poids fort de l'adresse de la page à contrôler à partir du rang, dans le compteur, du premier mot trouvé contenant un bit correspondant à un transistor effacé, et des moyens pour calculer des bits de poids faible de l'adresse de la page à contrôler à partir du rang, dans le premier mot trouvé, du premier bit correspondant à un transistor effacé.

Selon un mode de réalisation, les moyens d'incrémentation du compteur sont agencés pour programmer au moins un transistor à grille flottante du compteur sans effacer les autres transistors du compteur, le transistor programmé à chaque nouvelle incrémentation étant le transistor suivant le transistor programmé à l'incrémentation précédente, selon un sens de lecture du compteur.

Selon un mode de réalisation, les transistors à grille flottante du compteur sont agencés dans un secteur exclusivement dédié au compteur, de sorte que des tensions de programmation appliquées à des transistors à grille flottante d'un autre secteur de la mémoire ne se répercutent pas sur les transistors à grille flottante du compteur.

Selon un mode de réalisation, les moyens de contrôle d'au moins une page sont agencés pour contrôler une page mot à mot, le contrôle d'un mot comprenant la lecture du mot avec la première tension de lecture, la lecture du mot avec la deuxième tension de lecture, la comparaison des résultats des deux lectures et la reprogrammation des transistors du mot si les deux lectures donnent des résultats différents.

Selon un mode de réalisation, la tension d'effacement positive est appliquée aux électrodes de source ou de drain des transistors à grille flottante par l'intermédiaire du matériau formant le canal des transistors.

Ces objets, caractéristiques et avantages ainsi que d'autres de la présente invention seront exposés plus en détail dans la description suivante d'un procédé d'effacement de page et d'un procédé de contrôle de cellules mémoire selon l'invention, et d'une mémoire FLASH mettant en oeuvre ces deux procédés, faite à titre non limitatif en relation avec les figures jointes parmi lesquelles :
- la figure 1 précédemment décrite représente un plan mémoire FLASH,
- la figure 2 est une vue en coupe schématique de deux transistors à grille flottante et illustre le procédé d'effacement de page selon l'invention,
- la figure 3A illustre schématiquement la mise en oeuvre du procédé d'effacement de page dans une mémoire FLASH,
- la figure 3B illustre schématiquement la programmation d'un mot dans une mémoire FLASH,
- la figure 4 représente un décodeur de ligne de mot classique,
- la figure 5 représente un décodeur de ligne de mot selon l'invention,
- la figure 6 est le schéma électrique d'un circuit adaptateur de tension représenté sous forme de bloc en figure 5,
- la figure 7 représente des courbes de distribution statistique de tensions de seuil de transistors à grille flottante,
- la figure. 8 représente une mémoire FLASH selon l'invention, comprenant des moyens de mise en oeuvre du procédé d'effacement selon l'invention et d'un procédé de contrôle et de rafraîchissement selon l'invention, et
- la figure 9 illustre un procédé de lecture d'un compteur selon l'invention.

### Effacement sélectif d'une page de mémoire FLASH

La figure 2 est une vue en coupe de deux transistors à grille flottante FGTᵢ, FGTᵢ₊₁ de type NMOS, prévus pour être effacées selon la méthode d'effacement par le canal. A cet effet, les transistors FGT sont réalisés selon la technique dite "triple caisson", ce qui signifie que le matériau constituant le canal des transistors est un caisson 1 de type P implanté dans un caisson 2 de type N lui-même implanté dans un substrat 3 de type P. Le caisson 1 est ainsi isolé électriquement du substrat 3 et peut être porté à une tension V_{B} par l'intermédiaire d'un contact de type P+ tandis que le substrat 3 est à la masse.

La grille G de chaque transistor comprend une grille flottante FG déposée sur le caisson 1 par l'intermédiaire d'une fine couche d'oxyde OX1, et une grille de contrôle CG déposée sur la grille flottante FG par l'intermédiaire d'une autre couche d'oxyde OX2. Les épaisseurs des couches ne sont pas représentées à l'échelle pour des raisons de lisibilité de la figure. La région de canal CHN de chaque transistor s'étend sous l'oxyde de grille OX1 et est délimitée par des régions de source et de drain de type N+ implantées dans le caisson 1.

Lors de l'effacement des transistors FGTᵢ, FGTᵢ₊₁, le caisson 1 est porté à une tension V_{B} positive, par exemple 8 V, et une tension d'effacement V_{ER+} de l'ordre de 7,5 V apparaît sur les sources S des transistor, par l'intermédiaire des jonctions canal/drain dans le sens passant, comme représenté schématiquement par des diodes. La tension V_{ER+} apparaît également sur les régions de drain, qui sont portées à haute impédance par un décodeur de colonne (non représenté).

Dans l'art antérieur, l'application de la tension V_{ER+} va de pair avec l'application d'une tension d'effacement négative V_{ER-} sur toutes les grilles des transistors d'un même secteur, par inhibition d'un décodeur de ligne de mot, ce qui entraîne l'effacement simultané de tous les transistors du même secteur, un secteur comprenant tous les transistors dont le canal est formé dans le même caisson 1.

Pour obtenir un effacement sélectif par page, l'idée de la présente invention est d'appliquer sur la grille des transistors ne devant pas être effacés une tension d'inhibition positive V_{INHIB} qui compense tout ou partie du champ électrique créé par la tension V_{ER+}.

A titre d'exemple, supposons que les transistors FGTᵢ, FGTᵢ₊₁ ont été programmés, que le transistor FGTᵢ est connecté à une ligne de mot WLᵢ devant être effacée et que le transistor FGTᵢ₊₁ est connecté à une ligne de mot WLᵢ₊₁ ne devant pas être effacée. Selon l'invention, le transistor FGTᵢ₊₁ reçoit sur sa grille la tension d'inhibition positive V_{INHIB} pendant que le transistor FGTᵢ reçoit sur sa grille la tension d'effacement négative V_{ER-}. La tension V_{IHNIB} est comprise entre 0V et 8V et est de préférence de l'ordre de 4V pour pouvoir être délivrée par un décodeur alimenté sous 4 à 5V, comme cela sera vu plus loin. La tension V_{INHIB} compense tout ou partie du champ électrique créé par la tension V_{ER+} et s'oppose à l'effacement parasite du transistor FGTᵢ₊₁.

En pratique, une tension V_{INHIB} de l'ordre de 4V pour une tension d'effacement V_{ER+} de l'ordre de 7,5V supprime tout stress électrique sur le transistor FGTᵢ₊₁, de sorte que des opérations d'effacement répétées sur le transistor FGTᵢ n'entraînent pas, à long terme l'effacement parasite du transistor FGTᵢ₊₁. Une tension V_{INHIB} inférieure à 4V, par exemple de l'ordre de 1 à 2V, peut par contre entraîner un effacement progressif du transistor FGTᵢ₊₁ et de façon générale des autres transistors du secteur recevant la tension d'effacement sur leur source. Un procédé de contrôle et de rafraîchissement des cellules mémoire, permettant de pallier cet inconvénient, sera décrit plus loin.

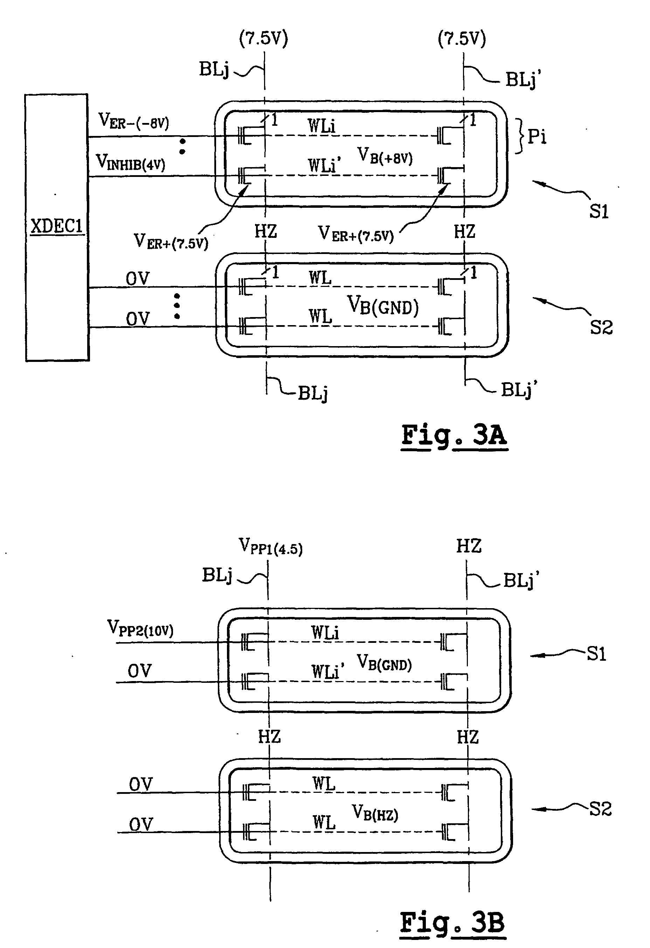

La figure 3A illustre la mise en oeuvre du procédé de l'invention dans une mémoire FLASH comprenant deux secteurs S1, S2, chaque secteur étant formé par un caisson P implanté dans un caisson N. Les drains des transistors à grille flottante de chaque secteur sont connectés à des lignes de bit BLⱼ, BLⱼ' contrôlées par un décodeur de colonne (non représenté), et les grilles des transistors à grille flottante sont connectées à des lignes de mot WLᵢ, WLᵢ' contrôlées par un décodeur de ligne de mot XDEC1. L'isolement électrique des lignes de bit de même rang de chaque secteur, par exemple la ligne BLⱼ du secteur S1 et la ligne BLⱼ du secteur S2, est assuré par un décodage local au niveau des secteurs qui est en soi classique et n'est pas représenté sur la figure.

Supposons par exemple que la page Pᵢ du secteur S1 correspondant à la ligne de mot WLᵢ doive être effacée sans effacer les autres pages du secteur S1 ni celles du secteur S2. Le caisson du secteur S1 est porté à une tension V_{B} de plusieurs volts, par exemple 8 V comme décrit plus haut, de sorte que la tension d'effacement positive V_{ER+} apparaît sur toutes les sources des transistors du secteur S1. Selon l'invention, le décodeur XDEC1 délivre la tension d'effacement négative V_{ER-} sur la ligne de mot à effacer WLᵢ et délivre la tension d'inhibition V_{INHIB} sur toutes les autres lignes de mot WLᵢ' du secteur S1. Ainsi, seuls les transistors de la page Pᵢ sont effacés et le stress électrique subi par les transistors des autres pages du secteur S1 est négligeable, comme cela a été expliqué.

Parallèlement, dans le secteur S2, toutes les lignes de bit BLⱼ, BLⱼ' sont portées à haute impédance (l'isolement étant obtenu par un décodage local comme indiqué plus haut), toutes les lignes de mot WL reçoivent une tension nulle (GND) et le caisson du secteur S2 est connecté à la masse (GND) . Les transistors du secteur S2 sont donc entièrement isolés des tensions d'effacement apparaissant dans le secteur S1.

Bien entendu, le procédé de l'invention peut être appliqué à l'effacement simultané de plusieurs pages d'un secteur tout en préservant de l'effacement une ou plusieurs autres pages du même secteur. Toutefois, dans ce qui suit, on considérera qu'un cycle d'effacement comprend l'effacement d'une page et une seule sans effacement des autres pages du secteur, ce qui correspond au mode de réalisation généralement visé en pratique.

Dans une mémoire FLASH selon l'invention, le processus de programmation d'un mot après effacement d'une page est réalisé conformément à la pratique antérieure, comme illustré en figure 3B. La programmation d'un mot est réalisée en appliquant au drain des transistors à programmer une tension V_{PP1} de 4 à 6 V, par l'intermédiaire des lignes de bit BLⱼ correspondantes, et en appliquant à la grille des transistors une tension de programmation V_{PP2} de l'ordre de 10 à 12 V, par l'intermédiaire de la ligne de mot correspondante WLᵢ. Le caisson correspondant au secteur considéré est porté à la masse (V_{B}=GND) . Les transistors recevant les tensions V_{PP1} et V_{PP2} sont dans l'état passant et fortement polarisés pendant l'opération. Le courant de programmation étant non négligeable, on ne programme simultanément qu'un nombre réduit de transistors, généralement huit transistors soit un octet ayant tous ses bits à 0. Les lignes de bit BLⱼ' ne correspondant pas au mot à programmer sont portées à haute impédance (HZ) et les lignes de mot WL ne correspondant pas à la page où se trouve le mot à programmer sont maintenues à 0V (GND). Dans le secteur voisin S2, toutes les lignes de bit sont portées à haute impédance (HZ) et toutes les lignes de mot sont maintenues à 0V.

### Aspects de l'invention concernant les décodeurs de ligne de mot

La mise en oeuvre du procédé selon l'invention nécessite la prévision d'un décodeur de ligne de mot XDEC1 capable de délivrer sélectivement la tension négative V_{ER-} à la ligne de mot WLᵢ correspondant à la page Pᵢ à effacer, tout en appliquant la tension V_{INHIB} aux autres lignes de mot WLᵢ' du secteur considéré.

Or, les décodeurs de ligne de mot classiques ne permettent pas une application sélective de la tension négative V_{ER-} à une ligne de mot désignée par un adresse déterminée, la tension V_{ER-} étant appliquée à toutes les lignes de mot du secteur à effacer.

### Rappels concernant les décodeurs de ligne de mot classiques à tension négative

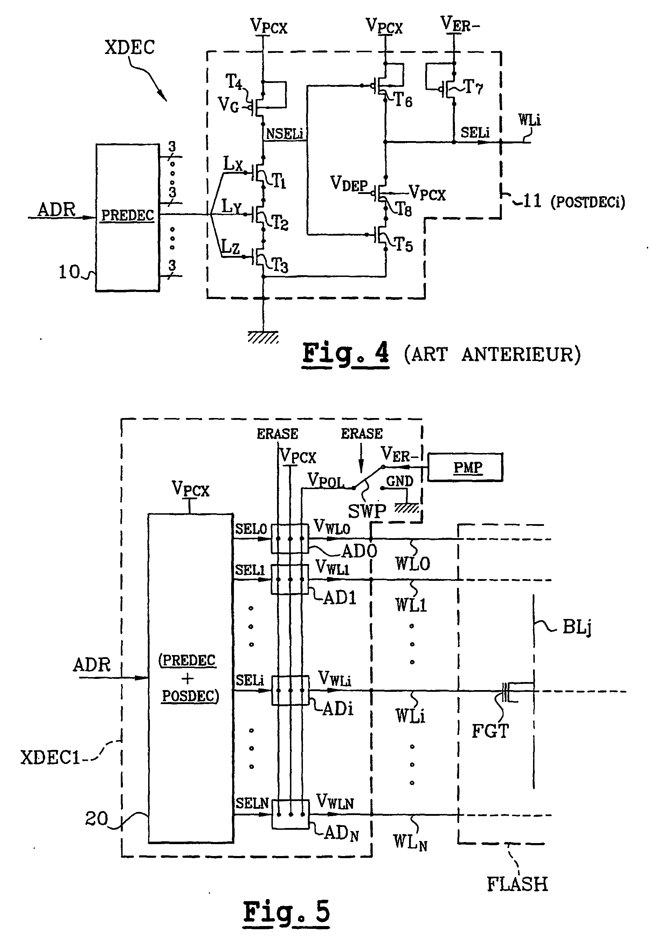

La figure 4 représente un décodeur de ligne de mot classique XDEC, comprenant un prédécodeur 10 (PREDEC) et une pluralité de postdécodeurs 11 (POSTDECᵢ) , un seul postdécodeur 11 de rang i étant représenté. Le prédécodeur 10 reçoit en entrée une adresse ADR de sélection d'une page et comprend une pluralité de sorties, en nombre égal au nombre de lignes de mot à contrôler. Sur chacune de ces sorties, le prédécodeur délivre des signaux de sélection Lx, Ly, Lz qui sont appliqués à un postdécodeur 11 de rang i. Le postdécodeur 11 délivre un signal de sélection SELᵢ appliqué à la ligne de mot WLᵢ de rang correspondant.

Chaque postdécodeur 11 comprend en entrée une porte NON ET (NAND) comprenant trois transistors NMOS en série T1, T2, T3 formant la partie de rappel au niveau bas (partie "pull-down") de la porte NON ET. La partie de rappel au niveau haut ("pull-up") de la porte NON ET, qui tire le noeud de sortie à une tension positive V_{PCX}, est formée par un transistor PMOS T4 piloté par une tension VG. Les grilles des transistors T1, T2 et T3 sont respectivement pilotées par les signaux Lx, Ly, Lz. Selon la valeur de ces signaux, la porte NON ET délivre un signal NSELᵢ égal à 1 (V_{PCX}) ou à 0 (GND). Le signal NSELᵢ est appliqué à une porte inverseuse polarisée par la tension V_{PCX}, comprenant un transistor NMOS T5 et un transistor PMOS T6. Le noeeud de sortie de la porte inverseuse délivre un signal de sélection SELᵢ qui peut être égal à V_{PCX} ("1" logique) ou à 0V ("0" logique).

La tension V_{PCX} est égale à une tension V_{READ} en mode lecture et est égale à la tension de programmation V_{PP2} en mode programmation. En mode effacement, la tension négative V_{ER-} est délivrée par un transistor PMOS T7 agencé en diode, dont le drain reçoit la tension V_{ER-} et dont la source est connectée à la sortie de la porte inverseuse T5/T6. Afin d'éviter une fuite de courant vers la masse par l'intermédiaire du transistor T5, un transistor d'isolement PMOS T8, piloté par une tension négative V_{DEP}, est agencé entre le noeud de sortie de la porte inverseuse T5/T6 et le drain du transistor T5.

Lorsque la tension d'effacement négative V_{ER-} est appliquée au postdécodeur 11, la porte inverseuse T5/T6 est maintenue dans l'état haute impédance (transistor T4 passant) et le postdécodeur est inhibé. Ainsi, tous les postdécodeurs 11 du décodeur XDEC délivrent la tension négative V_{ER-} ce qui entraîne l'effacement de toutes les pages d'un secteur.

### Exemple de décodeur de ligne de mot selon l'invention

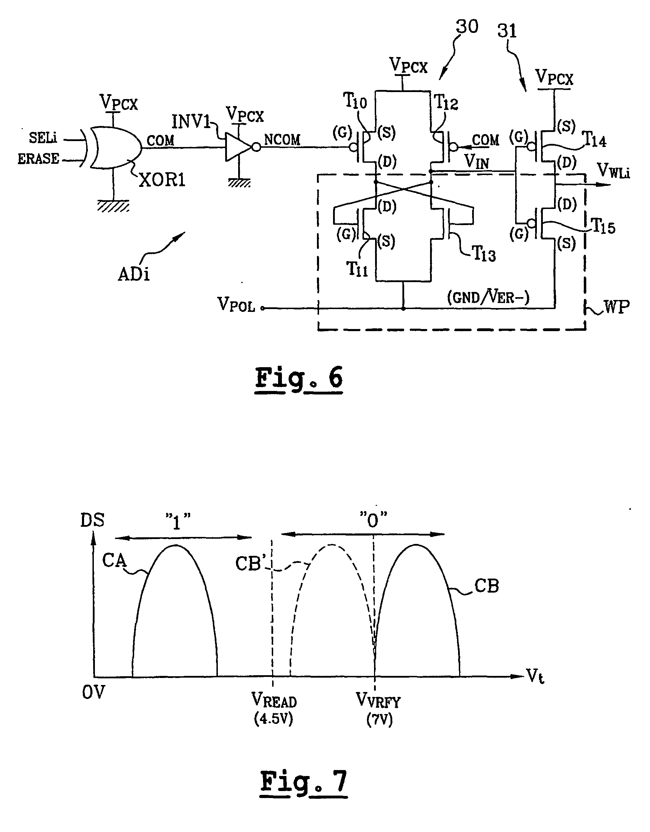

La figure 5 représente un décodeur de ligne de mot XDEC1 selon l'invention, capable de délivrer sélectivement une tension d'effacement négative V_{ER-} sur une ligne de mot WLᵢ désignée par une adresse ADR, tout en délivrant une tension d'inhibition V_{INHIB} aux autres lignes de mot d'un secteur. Notons que le décodeur XDEC1 représenté est prévu pour piloter les lignes de mot d'un même secteur. Cette architecture de décodeur doit ainsi être dupliquée en plusieurs exemplaires dans une mémoire comprenant plusieurs secteurs, de manière à inhiber les décodeurs XDEC1 rattachés aux secteurs qui ne sont pas concernés par une opération de programmation ou d'effacement se déroulant dans un autre secteur.

Le décodeur XDEC1 comprend un étage de décodage classique 20 constitué par le prédécodeur PREDEC décrit plus haut et par une pluralité de postdécodeurs POSTDEC délivrant chacun un signal de sélection de page SEL₀, SEL₁...SELᵢ,...SEL_{N} fonction de l'adresse ADR reçue en entrée. Les postdécodeurs sont ici du type à tension positive, et correspondent au postdécodeur 11 représenté en figure 4 dans lequel les transistors T7 et T8 sont supprimés. L'étage de décodage 20 étant alimenté par la tension V_{PCX}, les signaux de sélection délivrés SELᵢ sont ainsi égaux à V_{PCX} ou à 0V.

Selon l'invention, le décodeur XDEC1 comprend une pluralité de circuits adaptateurs de tension AD₀, AD₁,...ADᵢ,...AD_{N} recevant chacun en entrée un signal de sélection SEL₀, SEL₁,... SELᵢ, ... SEL_{N} et délivrant aux lignes de mot WL₀, WL₁,... WLᵢ,..WL_{N} du plan mémoire FLASH des tensions V_{WL0}, V_{WL1},... V_{WLi}, ... V_{WLN} qui peuvent être positives, négatives ou nulles selon l'opération en cours d'exécution et la valeur du signal SELᵢ reçu en entrée. Chaque circuit adaptateur ADᵢ reçoit sur une autre entrée un signal ERASE, qui est par exemple égal à 1 en mode effacement de page, et est alimenté par la tension V_{PCX} et par une tension V_{POL}.

La tension V_{PCX} est égale à la tension V_{READ} en mode lecture, à la tension de programmation V_{PP2} en mode programmation et à la tension d'inhibition V_{INHIB} en mode effacement. D'autre part, la tension V_{POL} est égale à la tension d'effacement négative V_{ER-} en mode effacement et est égale à 0V dans les autres modes de fonctionnement de la mémoire. La tension V_{POL} est par exemple délivrée par un interrupteur SWP à deux entrées piloté par le signal ERASE, une entrée de l'interrupteur SWP recevant la tension V_{ER-} délivrée par une pompe de charge PMP et l'autre entrée de l'interrupteur étant connectée à la masse. Lorsque le signal ERASE est à 1, l'interrupteur SWP délivre la tension V_{ER-}. Lorsque le signal BRASE est à 0, l'interrupteur SWP connecte à la masse (GND) la ligne de distribution de la tension V_{POL}.

La fonction de transfert de chaque circuit adaptateur de tension ADᵢ est décrite par le tableau 1 ci-après (les signaux COM et NCOM sont des signaux intermédiaires décrits plus loin). On voit qu'en mode effacement (ERASE=1) la tension V_{WLi} appliquée à une ligne de mot WLᵢ est égale à V_{ER-} si la ligne de mot est sélectionnée (SELᵢ = 1) ou est égale à V_{INHIB} si la ligne de mot n'est pas sélectionnée (SELᵢ = 0). En dehors des périodes d'effacement (ERASE=0) , la tension V_{WLi} appliquée à une ligne de mot WLᵢ sélectionnée (SELᵢ=1) est égale à la tension V_{PCX}, qui peut servir de tension de lecture V_{READ} ou de tension de programmation V_{PP2} selon l'opération en cours de réalisation, tandis que la tension V_{WLi} appliquée à une ligne de mot WLᵢ non sélectionnée (SELᵢ=0) est nulle.

**Tableau 1**

| **ERASE** | **SEL**_{**i**} | **COM** | **NCOM** | **V**_{**WLi**} |
|---|---|---|---|---|
| 0 | 0 | 0 | 1 | V_{WLi} = V_{POL} = GND |
| 0 | 1 | 1 | 0 | V_{WLi} = V_{PCX} = V_{READ} (4,5V) ou V_{PP2} (8-10V) |
| **1** | **0** | 1 | 0 | V_{WLi} = V_{PCX} = V_{INHIB} (4V) |
| **1** | **1** | 0 | 1 | V_{WLi} = V_{POL} = V_{ER-} (-8V) |

La figure 6 représente un mode de réalisation d'un circuit ADᵢ selon l'invention. Le circuit ADᵢ comprend une porte XOR1 de type OU EXCLUSIF recevant en entrée les signaux SELᵢ et ERASE et délivrant un signal COM. Le signal COM est appliqué à une porte inverseuse INV1 délivrant un signal NCOM. La porte XOR1 et la porte INV1 sont alimentées par la tension V_{PCX}, de sorte que les signaux COM et NCOM ont pour valeur la tension V_{PCX} lorsqu'ils sont à "1". Les signaux COM et NCOM sont appliqués à un étage pilote 30 (étage "driver") dont la sortie commande un étage inverseur 31.

L'étage pilote 30 comprend deux branches. en parallèle comprenant chacune un transistor PMOS, respectivement T10, T12, en série avec un transistor NMOS, respectivement T11, T13. Les drains des transistors T10, T12 reçoivent la tension V_{PCX} tandis que les sources des transistors T11, T13 reçoivent la tension V_{POL}, qui peut être égale au potentiel de masse GND ou à la tension négative V_{ER-} comme cela a été décrit plus haut. Le point milieu de la branche T12/T13 est connecté à la grille du transistor T11 et le point milieu de la branche T10/T11 est connecté à la grille du transistor T13.

L'étage inverseur 31 comprend un transistor PMOS T14 en série avec un transistor NMOS T15, le transistor T14 recevant sur sa source la tension V_{PCX} et le transistor T15 recevant sur sa source la tension V_{POL}. Les grilles des transistors sont pilotées par le point milieu de la branche T12/T13, et le point milieu de l'étage inverseur T14/T15 délivre la tension V_{WLi}.

Les transistors NMOS T11, T13 et T15 sont réalisés dans un caisson WP de type P isolé du substrat par un caisson N, selon la technique triple caisson décrite plus haut.

Le fonctionnement du circuit adaptateur ADᵢ est décrit par le tableau 1 ci-dessus. L'étage pilote 30, qui reçoit la tension V_{POL} en tant que tension de rappel au niveau bas (tension de "pull-down") , permet d'appliquer à la grille du transistor T15 de l'étage inverseur 31 une tension de blocage égale à V_{ER-} quand le drain du transistor T15 reçoit la tension V_{ER-} (V_{POL}=V_{ER-}) ou une tension de blocage égale à 0 V quand le drain du transistor T15 est à la masse (V_{POL}=GND) .

### Contrôle et rafraîchissement des cellules mémoire

Comme on l'a indiqué plus haut, la prévision d'une tension d'inhibition de faible valeur peut conduire à un effacement progressif des cellules mémoire. Or, en pratique, et pour des raisons technologiques, il peut être souhaité de mettre en oeuvre le procédé de l'invention avec une tension d'inhibition de faible valeur, de l'ordre de 1 à 2V, plutôt qu'avec une tension d'inhibition élevée, de l'ordre de 4V ou plus.

Afin de pallier cet inconvénient, une idée de la présente invention est de contrôler, après chaque écriture d'une page, les transistors à grille flottante de K pages de la mémoire, et de rafraîchir si nécessaire les transistors ayant été contrôlés. on désigne par "écriture d'une page" un cycle d'effacement de la page (écriture collective de "1") ou un cycle d'effacement/programmation de la page (écriture collective de "1" puis écriture individuelle de "0" dans tout ou partie des cellules mémoire de la page).

Le nombre K de pages contrôlées est avantageusement inférieur au nombre total de pages de la mémoire et est égal à 1 dans un mode de réalisation préféré du procédé de l'invention. Les K pages contrôlées après chaque écriture doivent être différentes des K pages contrôlées au cours d'un cycle d'écriture précédent, afin de contrôler progressivement toutes les pages de la mémoire.

Une autre idée de l'invention, optionnelle mais avantageuse, est de gérer les adresses des pages à contrôler au moyen d'un compteur non volatile incrémenté d'une unité après chaque contrôle d'une page, le compteur étant réalisé au moyen de transistors à grille flottante du plan mémoire FLASH. De cette manière, il est possible de vérifier cycliquement toutes les pages de la mémoire en revenant à la première page de la mémoire par une remise à zéro du compteur, lorsque celui-ci atteint la dernière adresse mémoire.

Dans une mémoire comportant plusieurs secteurs, un tel compteur peut être prévu pour chaque secteur ou pour l'ensemble des secteurs. La prévision d'un tel compteur pose le problème de la durée de vie des transistors à grille flottante du compteur lui-même. En effet, si le compteur est effacé et reprogrammé avec une nouvelle valeur d'adresse après chaque écriture d'une page, le nombre de cycles d'effacement ou programmation des transistors du compteur va être très important, que le compteur soit affecté à un secteur ou à l'ensemble de la mémoire. Pour résoudre ce problème, la présente invention propose un mode de gestion de compteur consistant à programmer un transistor du compteur à chaque incrémentation de celui-ci, sans effacer ni reprogrammer les autres transistors du compteur sauf lorsque le compteur doit être remis à zéro. Ainsi, le comptage est fait selon la méthode des jetons, un jeton utilisé ne pouvant être réutilisé. L'adresse de la page à contrôler est déterminée par le rang du prochain jeton à utiliser, soit le rang du premier transistor non programmé rencontré selon le sens de lecture du compteur. Lorsque tous les jetons sont utilisés, le compteur est effacé et le comptage recommence à partir du premier jeton.

### Exemple de réalisation d'une mémoire effaçable par page comprenant des moyens de contrôle et de rafraîchissement de cellules mémoire

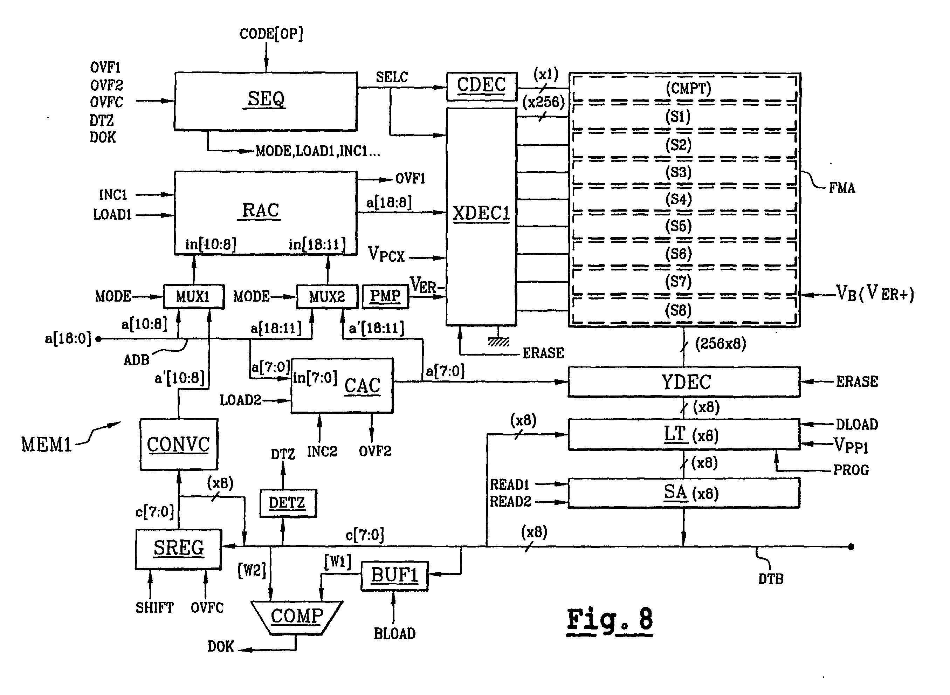

La figure 8 représente sous forme de blocs une mémoire MEM1 selon l'invention mettant en oeuvre le procédé d'effacement sélectif selon l'invention et un procédé selon l'invention de contrôle et de rafraîchissement de cellules mémoire. La mémoire MEM1 comprend un plan mémoire FMA ("Flash Memory Array" ) comprenant ici huit secteurs mémoire S1 à S8 et un secteur supplémentaire formant un compteur CMPT selon l'invention. Chacun des secteurs S1 à S8, isolé des autres par la technique du triple caisson, compte 256 lignes de mot WLᵢ ou pages comprenant chacune 256 mots de 8 bits (octets), soit 2048 lignes de bit BLⱼ. La mémoire compte ainsi au total 2048 pages réparties dans les huit secteurs et offre une capacité de stockage de 4 Mbits.

Le compteur CMPT ne comprend ici qu'une ligne de mot et est dédié au contrôle des pages des huit secteurs S1 à S8. Le compteur CMPT comporte 2048 bits, de sorte qu'un bit du compteur peut être affecté à la désignation d'une page selon la méthode des jetons.

Par ailleurs, la mémoire est pourvue d'un décodeur de ligne de mot XDEC1 selon l'invention, capable d'appliquer à une ligne de mot WLᵢ la tension d'effacement V_{ER-} ou la tension d'inhibition V_{INHIB}. L'adressage du compteur CMPT est assuré par un décodeur spécifique CDEC activé par un signal SELC qui inhibe automatiquement le décodeur XDEC1.

La mémoire MEM1 comprend également un décodeur de colonne YDEC, un registre de programmation LT, un circuit de lecture SA, un compteur d'adresses de ligne RAC et un compteur d'adresses de colonne CAC.

Le décodeur de colonne YDEC comprend 2048 entrées/sorties connectées au 2048 lignes de bit du plan mémoire FMA et huit entrées/sorties connectées au registre de programmation LT et au circuit de lecture SA.

Le registre LT comprend classiquement huit verrous haute tension ("latches") (non représentés) permettant la programmation d'un octet dans le plan mémoire, les verrous étant connectés en sortie aux huit entrées/sorties du décodeur de colonne YDEC et connectés en entrée à un bus de données DTB de huit bits. Le registre LT enregistre un octet présent sur le bus DTB sur réception d'un signal DLOAD, et délivre la tension de programmation V_{PP1} sur ses sorties (selon les valeurs des bits de l'octet chargé) sur réception d'un signal de programmation PROG.

Le circuit de lecture SA, activé par un signal READ, comprend classiquement huit amplificateurs de lecture ("sense amplifiers") (non représentés) connectés aux huit entrées/sorties du décodeur de colonne YDEC, et est connecté en sortie au bus de données DTB.

Le compteur RAC ("Row Address Counter") reçoit en entrée onze bits d'adresse de poids fort a[18:8] présents sur un bus d'adresse ADB, et délivre ces bits d'adresse au décodeur de colonne XDEC1. Le compteur RAC est piloté par un signal LOAD1 de chargement des bits d'adresse et peut être incrémenté par un signal INC1. Il délivre un signal OVFl en cas de débordement après incrémentation. Les bits d'adresse de poids fort a[18:8] sont appliqués au compteur RAC par l'intermédiaire de deux multiplexeurs MUX1, MUX2 à deux entrées chacun. Plus particulièrement, le compteur RAC reçoit trois bits d'adresse a[10:8] sur des entrées in[10:8] par l'intermédiaire du multiplexeur MUX1 dont une entrée est connectée au bus ADB, et reçoit huit bits d'adresse a [18 :11] sur des entrées in[18:11] par l'intermédiaire du multiplexeur MUX2 dont une entrée est également connectée au bus ADB. Les multiplexeurs MUX1, MUX2 sont pilotés par un signal MODE décrit plus loin.

Le compteur CAC ("Column Address Counter") reçoit huit bits d'adresse de poids faible a[7:0] sur des entrées in[7:0] connectées au bus ADB. La sortie du compteur CAC délivre les bits d'adresse a [7:0] sur l'entrée d'adresse du décodeur de colonne YDEC et est également connectée à la deuxième entrée du multiplexeur MUX2. Le compteur CAC est piloté par un signal de chargement LOAD2, par un signal d'incrémentation INC2 et délivre le cas échéant un signal de débordement OVF2.

La mémoire MEM1 comprend également un registre à décalage SREG à entrée/sortie parallèle, un circuit CONV, un détecteur de zéro DETZ, un tampon BUF1, un comparateur logique COMP et un séquenceur SEQ.

Le registre SREG a son entrée connectée au bus de données DTB et sa sortie est connectée à l'entrée d'un circuit de conversion CONVC et au bus de données DTB. Le registre SREG est piloté par un signal de décalage SHIFT et délivre un signal de débordement OVFC lorsque son contenu atteint la valeur 00_{H} après un décalage à droite.

Le circuit CONVC est un circuit à logique câblée réalisant une fonction de décodage décrite plus loin. Sa sortie est connectée à la deuxième entrée du multiplexeur MUX1.

Le détecteur DETZ est connecté en entrée au bus de données DTB, et délivre un signal DTZ à 1 lorsqu'un octet égal à 00_{H} est présent sur le bus DTB.

Le tampon BUF1 a son entrée connectée au bus DTB et sa sortie est appliquée sur une entrée du comparateur COMP, dont l'autre entrée est connectée au bus DTB. Le tampon BUF1 charge une donnée sur réception d'un signal de chargement BLOAD, et le comparateur COMP délivre un signal DOK ("Data OK") lorsqu'un mot W2 présent sur le bus de donnée DTB est identique à un mot W1 présent à la sortie du tampon BUF1.

Enfin, le séquenceur SEQ, à logique câblée ou à microprocesseur, par exemple un microcontrôleur, délivre l'ensemble des signaux de commande décrits ci-dessus et reçoit l'ensemble des signaux émis par les éléments décrits ci-dessus.

La mémoire MEM1 fonctionne de façon classique pendant les opérations de lecture, d'écriture ou d'effacement, les opérations à réaliser étant fournies au séquenceur sous forme de codes opération CODE[OP]. Le signal MODE est à 1 et les multiplexeurs MUX1, MUX2 connectent le bus d'adresse ADB sur les entrées in[10:8] et in[18:11] du compteur RAC, les bits d'adresse de poids fort se retrouvant ainsi en entrée du compteur RAC et les bits d'adresse de poids faible en entrée du compteur CAC. Conformément à l'invention, l'effacement d'une page d'adresse a[18:8] est assuré en appliquant la tension V_{ER-} aux grilles des transistors de la page, tandis que les transistors des autres pages du secteur visé reçoivent la tension d'inhibition V_{IHNIB} (V_{PCX}) . Parallèlement, la tension V_{B} est appliquée au caisson du secteur où se trouve la page à effacer, pour génération de la tension V_{ER+} sur les électrodes de source.

Lorsqu'une page a été effacée, le séquenceur SEQ déclenche une procédure de lecture du compteur CMPT visant à déterminer l'adresse d'une page devant être contrôlée. A cet effet, le séquenceur active le décodeur CDEC au moyen du signal SELC, met à zéro le compteur CAC et active le circuit de lecture SA (signal READ) . Le premier octet du compteur CMPT est délivré par le circuit SA sur le bus de données DTB. Si le signal STZ à la sortie du circuit de détection DETZ est à 1, cela signifie que le premier octet lu dans le compteur CMPT ne comprend que des zéros. En d'autre termes, cela signifie que les transistors à grille flottante dans lesquels est enregistré le premier octet du compteur CMPT sont tous programmés. Le séquenceur incrémente donc le compteur CAC d'une unité et lit l'octet suivant, ainsi de suite si nécessaire jusqu'à ce que le signal DTZ passe à 0. Lorsque le signal DTZ passe à 0, le séquenceur sait qu'un octet contenant un bit à 1, correspondant à un transistor effacé, a été trouvé. Il s'agit du premier octet non nul du compteur CMPT.

Les bits c[7:0] de l'octet non nul sont chargés dans le registre SREG et se retrouvent à l'entrée du circuit de conversion CONVC. Ce dernier délivre sur les entrées in [10:8] du compteur RAC, par l'intermédiaire du multiplexeur MUX1, les bits de poids faible a'[10:8] de l'adresse de la page à contrôler. La conversion des bits c[7:0] de l'octet non nul en bits d'adresse a' [10:8] est assurée par le circuit CONVC conformément à la table décrite par le tableau 2 ci-après.

Au même instant, les bits d'adresse de colonne a[7:0] de l'octet non nul du compteur CMPT, appliqués par le compteur CAC au décodeur YDEC, sont présents sur les entrées in[10:8] du compteur RAC en tant que bits d'adresse de poids fort a' [18:11] de l'adresse de la page à contrôler. L'adresse de la page à contrôler, comprenant les bits a' [10:8] et les bits a' [18:11] , est ainsi chargée dans le compteur RAC au moyen de la commande LOAD1 et le processus de contrôle de page peut commencer.

**Tableau 2 :**

| **table de conversion** | |
|---|---|
| **c[7:0]** | **a' [10:8]** |
| 1 1 1 1 1 1 1 1 | 000 |
| 0 1 1 1 1 1 1 1 | 001 |
| 0 0 1 1 1 1 1 1 | 010 |
| 0 0 0 1 1 1 1 1 | 011 |
| 0 0 0 0 1 1 1 1 | 100 |
| 0 0 0 0 0 1 1 1 | 101 |
| 0 0 0 0 0 0 1 1 | 110 |
| 0 0 0 0 0 0 0 1 | 111 |

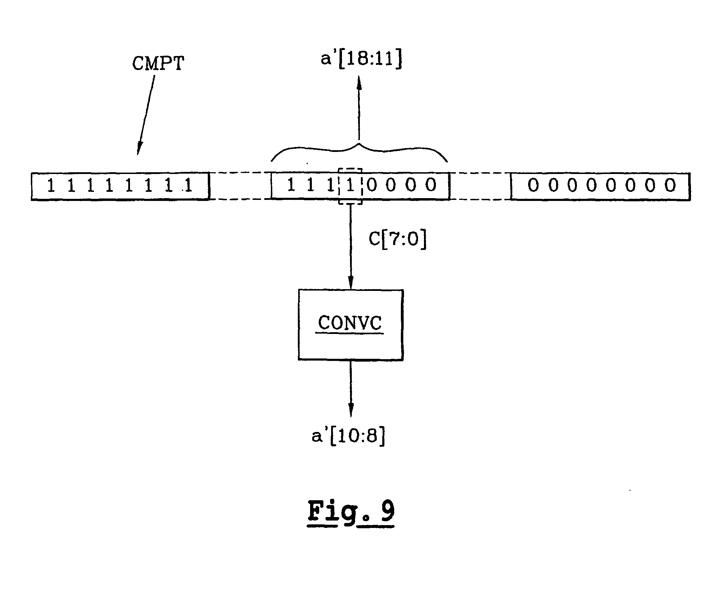

Le procédé de lecture du compteur OMET qui vient d'être décrit est illustré en figure 9. On voit que les bits de poids fort a' [18:11] de l'adresse de la page correspondent au rang, dans le compteur CMPT, du premier octet non nul trouvé. Il s'agit donc bien de l'adresse a [7:0] de la colonne contenant l'octet non nul. D'autre part, les bits de poids faible a'[10:8] de l'adresse de la page à contrôler correspondent au rang, dans le premier octet non nul, du premier bit non nul de l'octet. En définitive, l'adresse complète a' [18:8] déterminée par ce procédé correspond au rang dans le compteur CMPT du premier bit non nul, c'est-à-dire au rang du premier transistor non programmé.

Au cours de l'étape de contrôle, les octets de la page sélectionnée sont lus les uns après les autres en incrémentant le compteur CAC. Avantageusement, chaque octet est lu au moyen de deux tensions de lecture différentes, la première étant la tension de lecture V_{READ} conventionnelle et la deuxième une tension de vérification V_{VRFY} supérieure à V_{READ}. Les deux tensions sont obtenues en faisant varier la tension V_{PCX} appliquée au décodeur XDEC1.

La figure 7 illustre le procédé de contrôle et de rafraîchissement selon l'invention, et représente la répartition statistique DS des tensions de seuil Vt de transistors effacés (courbe CA, lecture d'un "1") et la répartition statistique des tensions de seuil Vt de transistors programmés (courbe CB, lecture d'un "0"). Sous l'effet du stress électrique, la courbe CB a tendance à se déplacer lentement vers la gauche, pour former une courbe CB'. Les transistors relevant de la courbe CB' ont perdu des charges électriques et présentent des tensions de seuil plus faibles que la normale. La tension V_{READ}, de l'ordre de 4,5V, se trouve à gauche des courbes CB et ce' et ne permet pas de distinguer un transistor relevant de la courbe CB ou un transistor relevant de la courbe CB'. La tension de vérification V_{VRFY}, par exemple 7V, se trouve par contre entre les deux courbes CB, CB' et permet de distinguer un transistor correctement programmé d'un transistor dont la grille flottante a perdu des charges électriques, car dans le premier cas le transistor restera bloqué et dans le second cas le transistor sera passant. La comparaison d'un octet lu au moyen des deux tensions VR_{EAD}, V_{VRFY} permet ainsi de détecter l'existence d'au moins un transistor programmé dont la tension de seuil est devenue plus faible que la tension V_{VRFY}.

La comparaison est faite simultanément sur les huit bits de chaque octet au moyen du comparateur COMP. L'octet W1 lu au moyen de la tension V_{VRFY} est stocké dans le tampon BUF1, et l'octet W2 lu avec la tension V_{READ} se retrouve sur le bus DTB et sur la deuxième entrée du comparateur. Si le signal DOK à la sortie du comparateur passe à 0, le séquenceur sait que tout ou partie des transistors programmés (s'il y en a) dans lesquels l'octet est enregistré ont perdu des charges électriques. Dans ce cas, l'octet W2, qui est l'octet de référence car il a été lu avec la tension V_{READ}, est chargé dans le registre de programmation LT et le séquenceur déclenche un cycle de programmation pour rafraîchir les cellules endommagées. Au cours du cycle de programmation, les transistors reprogrammés sont ceux qui correspondent à la lecture d'un bit à 0 avec la tension V_{READ} et à la lecture d'un bit à 1 avec la tension V_{VRFY}, les transistors effacés n'étant pas concernés par l'opération.

Lorsque tous les octets de la page ont été contrôlés et que les cellules mémoire endommagées ont été reprogrammées, le séquenceur incrémente le compter CMPT d'une unité. Comme indiqué plus haut, cette incrémentation consiste à programmer le premier transistor non programmé trouvé à l'étape de recherche de l'adresse de la page à contrôler. A cet effet, le séquenceur applique au compteur CAC les bits d'adresse de poids fort a[18:11] se trouvant à la sortie du compteur RAC, en tant que bits d'adresse de colonne a[7:0] du premier octet non nul du compteur CMPT. Cette opération est l'inverse de celle faite précédemment pour trouver l'adresse de la page à contrôler, et fait intervenir une connexion entre la sortie du compteur RAC et l'entrée du compteur CAC, qui n'a pas été représentée en figure 8 pour ne pas surcharger le schéma. Une fois l'adresse de l'octet non nul récupérée par le compteur CAC, la valeur de l'octet non nul, conservée par le registre SREG, est incrémentée par décalage à droite (signal SHIFT). La valeur incrémentée est ensuite envoyée dans le registre LT pour programmation de l'octet. Un seul bit à 0 ayant été ajouté par le décalage à droite, la reprogrammation de l'octet non nul va entraîner la programmation du premier transistor à grille flottante effacé trouvé lors de la recherche de l'adresse de la page à contrôler, les transistors déjà programmés n'étant pas reprogrammés.

Si le registre SREG délivre le signal de débordement OVFC après insertion d'un bit à 0 par décalage à droite, cela signifie que l'octet ne contient que des zéros. Aussi, après avoir programmé l'octet à 0 dans le compteur CMPT, le séquenceur incrémente le compteur CAC à titre de vérification. Si le compteur CAC délivre le signal de débordement OVF2, cela signifie que l'octet à 0 était le dernier octet du compteur CMPT. Dans ce cas, le séquenceur sait qu'il devra remettre à zéro le compteur CMPT après le prochain cycle de vérification d'une page, la page restant à vérifier étant la dernière de la mémoire.

Le procédé de contrôle et de rafraîchissement de transistors qui vient d'être décrit est particulièrement simple à mettre en oeuvre et nécessite peu de moyens matériels. Il est en outre quasiment transparent pour l'utilisateur car le temps de contrôle et de reprogrammation éventuelle d'une page est de l'ordre de 200 µs, à comparer avec un temps de l'ordre de 1 275 µs (255x5µs) pour la programmation des 255 octets d'une page, auquel s'ajoute le temps nécessaire à l'effacement préalable de la page.

Il apparaîtra clairement à l'homme de l'art que la présente invention est susceptible de diverses variantes de réalisation.

D'une part, un compteur CMPT selon l'invention peut comprendre plusieurs lignes de mot, selon la taille du plan mémoire à contrôler. Par exemple, une mémoire de 16 secteurs et d'une capacité de 8 Mbits nécessitera un compteur de deux lignes de 2048 bits chacune, à moins que le compteur ne soit éclaté en plusieurs compteurs dédiés à chacun des secteurs.

D'autre part, bien que l'on ait proposé une méthode de comptage des lignes à rafraîchir dans laquelle un "jeton" correspond à un transistor et un seul, il est également possible à chaque incrémentation du compteur de programmer un groupe de transistors représentant un jeton, par exemple quatre transistors, pour pallier une éventuelle défaillance d'un transistor. Dans ce cas, la méthode pour retrouver l'adresse de la ligne à rafraîchir consiste à trouver dans le compteur le premier groupe de quatre bits comprenant au moins trois bits égaux à 1.

Enfin, le procédé selon l'invention peut s'appliquer à des cellules mémoire comprenant des transistors à grille flottante du type PMOS, la tension V_{ER-} étant dans ce cas appliquée aux drains et non aux sources des transistors.

## Revendications

1. Procédé d'enregistrement de données dans une mémoire FLASH comprenant au moins un secteur (S1), dans lequel l'effacement d'une page (Pᵢ) de la mémoire comprend l'application d'une tension d'effacement négative (V_{POL}, V_{ER-}) aux grilles des transistors à grille flottante de la page à effacer et l'application d'une tension d'effacement positive (V_{ER+}) aux électrodes de source ou de drain de tous les transistors à grille flottante du secteur (S1) de la mémoire comprenant la page à effacer, l'effacement d'une page comprenant l'application d'une tension d'inhibition positive (V_{INHIB}, V_{PCX}) aux grilles des transistors d'au moins une page de la mémoire ne devant pas être effacée, caractérisé et en ce qu'il comprend une étape de contrôle d'au moins une page de la mémoire, comprenant une première lecture de la page faite en appliquant une première tension de lecture (V_{READ}) aux grilles des transistors de la page, une seconde lecture de la page faite en appliquant une deuxième tension de lecture (V_{VRFY}) différente de la première tension de lecture aux grilles des transistors de la page, et une reprogrammation de transistors si les deux lectures donnent des résultats différents (W1, W2).

2. Procédé selon la revendication 1, dans lequel la deuxième tension de lecture (V_{VRFY}) est supérieure à la première tension de lecture (V_{READ}) , la première tension de lecture (V_{READ}) correspond à une tension de lecture normale utilisée pendant des phases de lecture de la mémoire, et la reprogrammation de transistors est faite en utilisant comme données de reprogrammation les données lues en appliquant la première tension de lecture (V_{READ}) .

3. Procédé selon l'une des revendications 1 et 2, dans lequel la tension d'inhibition (V_{INHIB}, V_{PCX}) est inférieure à la tension d'effacement positive (V_{ER+}) .

4. Procédé selon l'une des revendications 1 à 3, comprenant une étape consistant à prévoir dans la mémoire des circuits adaptateurs de tension (ADᵢ) recevant chacun en entrée un signal de sélection de page (SELᵢ) et délivrant aux grilles des transistors de la page correspondante :
- une tension positive (V_{PCX}) , lorsque le signal de sélection de page présente une première valeur ("0") correspondant à la non-sélection de la page et que la mémoire est en mode effacement (ERASE) ou lorsque le signal de sélection présente une deuxième valeur ("1") correspondant à la sélection de la page et que la mémoire n'est pas en mode effacement, ou
- une tension de polarisation (V_{POL}) inférieure à la tension positive (V_{PCX}, V_{INHIB}) , lorsque le signal de sélection présente la deuxième valeur ("1") et que la mémoire est en mode effacement ou lorsque le signal de sélection présente la première valeur ("0") et que la mémoire n'est pas en mode effacement.

5. Procédé selon la revendication 4, dans lequel les circuits adaptateurs de tension (ADᵢ) reçoivent :
- pendant l'effacement d'une page, une tension de polarisation (V_{POL}) égale à la tension d'effacement négative (V_{ER-}) et une tension positive (V_{PCX}) égale à la tension d'inhibition (V_{INHIB}) , et
- pendant la lecture d'un mot dans la mémoire, une tension de polarisation (V_{POL}) égale au potentiel de masse (GND) et une tension positive (V_{PCX}) égale à une tension de lecture (V_{READ}) .

6. Procédé selon l'une des revendications 1 à 5 comprenant, après chaque écriture d'une page dans un secteur de la mémoire, le contrôle de K pages du secteur considéré, K étant strictement inférieur au nombre de pages du secteur considéré et au moins égal à 1.

7. Procédé selon l'une des revendications 1 à 6, dans lequel l'étape de contrôle est appliquée à au moins une page de la mémoire se trouvant à une adresse lue dans un compteur non volatile (CMPT) formé par au moins une rangée de transistors à grille flottante.

8. Procédé selon la revendication 7, dans lequel le compteur est incrémenté d'une unité (SHIFT) après le contrôle d'au moins une page, en programmant au moins un transistor à grille flottante du compteur sans effacer les autres transistors du compteur, le transistor programmé à chaque nouvelle incrémentation du compteur étant le transistor suivant le transistor programme à l'incrémentation précédente, selon un sens de lecture du compteur.

9. Procédé selon l'une des revendications 7 et 8, dans lequel le compteur comprend une pluralité de mots de rang croissant, et la lecture dans le compteur de l'adresse d'au moins une page à contrôler comprend les étapes consistant à :
- lire le compteur mot à mot jusqu'à trouver un mot (c[7:0]) comprenant un bit correspondant à un transistor effacé,
- déterminer les bits de poids fort (a'[18:11]) de l'adresse de la page à contrôler au moyen du rang, dans le compteur, du premier mot trouvé comprenant un bit correspondant à un transistor effacé, et
- déterminer les bits de poids faible (a'[11:8]) de l'adresse de la page à contrôler au moyen du rang, dans le premier mot trouvé, du premier bit correspondant à un transistor effacé.

10. Procédé selon l'une des revendications 7 à 9, dans lequel les transistors à grille flottante du compteur sont agencés dans un secteur exclusivement dédié au compteur, de sorte que des tensions de programmation appliquées à des transistors à grille flottante d'un autre secteur (S1-S8) de la mémoire ne se répercutent pas sur les transistors à grille flottante du compteur.

11. Procédé selon l'une des revendications 1 à 10, dans lequel le contrôle d'une page est effectué mot à mot et le contrôle d'un mot comprend la lecture du mot avec la première tension de lecture (V_{READ}) , la lecture du mot avec la deuxième tension de lecture (V_{VRFY}) , et la reprogrammation de transistors si les deux lectures donnent des résultats différents (W1, W2).

12. Procédé selon l'une des revendications précédentes, dans lequel la tension d'effacement positive (V_{ER+}) est appliquée aux électrodes de source ou de drain des transistors à grille flottante par l'intermédiaire du matériau (1) formant le canal (CHN) des transistors.

13. Mémoire FLASH (MEM1) effaçable par page comprenant :
- un plan mémoire (FMA) comportant une pluralité de pages comprenant chacune des transistors à grille flottante connectés par leurs grilles à des lignes de mot (WLᵢ),
- un décodeur de ligne de mot (XDEC1) connecté aux lignes de mot de la mémoire,
- des moyens pour appliquer une tension d'effacement positive (V_{ER+}) aux électrodes de source ou de drain de tous les transistors à grille flottante d'un secteur comprenant une page à effacer,
le décodeur de ligne de mot (XDEC1) comprenant des moyens (ADᵢ) pour appliquer, lors de l'effacement d'une page, une tension d'effacement négative (V_{POL}, V_{ER-}) aux grilles des transistors de la page à effacer, tout en appliquant une tension d'inhibition positive (V_{INHIB}, V_{PCX}) aux grilles des transistors d'au moins une page ne devant pas être effacée, **caractérisé en ce qu'**elle comprend des moyens (CMPT, SREG, CONVC, DETZ, LT, XDEC1, SA, COMP) de contrôle d'au moins une page de la mémoire, agencés pour effectuer une première lecture de la page en appliquant une première tension de lecture (V_{READ}) aux grilles des transistors de la page, effectuer une seconde lecture de la page en appliquant une deuxième tension de lecture (V_{VRFY}) différente de la première tension de lecture, aux grilles des transistors de la page, et reprogrammer des transistors de la page si les deux lectures donnent des résultats différents (W1, W2).

14. Mémoire selon la revendication 13, dans laquelle la deuxième tension de lecture (V_{VRFY}) est supérieure à la première tension de lecture (V_{READ}), la première tension de lecture (V_{READ}) correspond à une tension de lecture normale utilisée pendant des phases de lecture de la mémoire, et la reprogrammation de transistors est faite en utilisant comme données de reprogrammation les données lues en appliquant la première tension de lecture (V_{READ}) .

15. Mémoire selon l'une des revendications 13 et 14, dans laquelle la tension d'inhibition (V_{INHIB}, V_{PCX}) délivrée par le décodeur de ligne de mot (XDEC1) est inférieure à la tension d'effacement positive (V_{ER+}) .

16. Mémoire selon l'une des revendications 13 à 15, dans laquelle le décodeur de ligne de mot (XDEC1) comprend des circuits adaptateurs de tension (ADᵢ) recevant en entrée un signal de sélection de page (SELᵢ) et délivrant aux grilles des transistors de la page correspondante :
- une tension positive (V_{PCX}) , lorsque le signal de sélection présente une première valeur ("0") correspondant à la non-sélection de la page et que la mémoire est en mode effacement (ERASE) ou lorsque le signal de sélection présente une deuxième valeur ("1") correspondant à la sélection de la page et que la mémoire n'est pas en mode effacement (ERASE), ou
- une tension de polarisation (V_{POL}) inférieure à la tension positive (V_{PCX}, V_{INHIB}) , lorsque le signal de sélection présente la deuxième valeur ("1") et que la mémoire est en mode effacement (ERASE) ou lorsque le signal de sélection présente la première valeur ("0") et que la mémoire n'est pas en mode effacement (ERASE) .

17. Mémoire selon la revendication 16, comprenant des moyens (PMP, SWP) pour fournir aux circuits adaptateurs de tension (ADᵢ) :
- pendant l'effacement d'une page, une tension de polarisation (V_{POL}) égale à la tension d'effacement négative (V_{ER-}) et une tension positive (V_{PCX}) égale à la tension d'inhibition (V_{IHNIB}) , et
- pendant la lecture d'un mot dans la mémoire, une tension de polarisation (V_{POL}) égale au potentiel de masse (GND) et une tension positive (V_{PCX}) égale à une tension de lecture (V_{READ}) .

18. Mémoire selon la revendication 17, dans laquelle le circuit adaptateur de tension (ADᵢ) comprend un étage inverseur de sortie (INV2) recevant d'une part la tension positive (V_{PCX}, V_{INHIB}) et d'autre part la tension de polarisation (V_{POL}, V_{ER-}, GND), et un étage de commande de l'étage inverseur comprenant une fonction logique OU EXCLUSIF (XOR) recevant en entrée le signal de sélection (SELᵢ) et un signal (ERASE) présentant une valeur déterminée pendant l'effacement d'une page.

19. Mémoire selon l'une des revendications 13 à 18 dans laquelle les moyens de contrôle sont agencés pour, après chaque écriture d'une page dans un secteur de la mémoire, contrôler K pages du secteur considéré, K étant strictement inférieur au nombre de pages du secteur considéré ét au moins égal à 1.

20. Mémoire selon l'une des revendications 13 à 19, dans laquelle les moyens de contrôle comprennent :
- un compteur non volatile (CMPT) formé par au moins une rangée de transistors à grille flottante,
- des moyens (SREG, CONVC, DETZ) pour lire dans le compteur l'adresse d'au moins une page à contrôler, et
- des moyens (SRBG, LT) d'incrémentation du compteur après le contrôle d'au moins une page.

21. Mémoire selon la revendication 20, dans laquelle les moyens pour lire l'adresse d'au moins une page à contrôler comprennent :
- des moyens (CDEC, SA, DETZ, CAC) de lecture mot à mot du compteur et de recherche d'un mot (c[7:0]) contenant un bit correspondant à un transistor effacé,
- des moyens (CONVC, MUX1) pour délivrer des bits de poids fort (a'[18:11]) de l'adresse de la page à contrôler à partir du rang, dans le compteur, du premier mot trouvé contenant un bit correspondant à un transistor effacé, et
- des moyens (CAC, MUX2) pour calculer des bits de poids faible (a' [11:8]) de l'adresse de la page à contrôler à partir du rang, dans le premier mot trouvé, du premier bit correspondant à un transistor effacé.

22. Mémoire selon l'une des revendications 20 et 21, dans laquelle les moyens (SREG, LT) d'incrémentation du compteur sont agencés pour programmer au moins un transistor à grille flottante du compteur sans effacer les autres transistors du compteur, le transistor programmé à chaque nouvelle incrémentation étant le transistor suivant le transistor programmé à l'incrémentation précédente, selon un sens de lecture du compteur.

23. Mémoire selon l'une des revendications 20 à 22, dans laquelle les transistors à grille flottante du compteur (CMPT) sont agencés dans un secteur exclusivement dédié au compteur, de sorte que des tensions de programmation appliquées à des transistors à grille flottante d'un autre secteur (S1-S8) de la mémoire ne se répercutent pas sur les transistors à grille flottante du compteur.

24. Mémoire selon l'une des revendications 13 à 23, dans laquelle les moyens de contrôle d'au moins une page sont agencés pour contrôler une page mot à mot, le contrôle d'un mot comprenant la lecture du mot avec la première tension de lecture (V_{READ}) , la lecture du mot avec la deuxième tension de lecture (V_{VRFY}) , la comparaison des résultats des deux lectures et la reprogrammation des transistors du mot si les deux lectures donnent des résultats différents.

25. Mémoire selon l'une des revendications 13 à 24, dans laquelle la tension d'effacement positive (V_{ER+}) est appliquée aux électrodes de source ou de drain des transistors à grille flottante par l'intermédiaire du matériau (1) formant le canal (CHN) des transistors.

## Patentansprüche

1. Verfahren zur Aufzeichnung von Daten in einem Flash-Speicher, umfassend mindestens einen Sektor (S1) , in dem das Löschen einer Seite (Pᵢ) des Speichers das Anlegen einer negativen Löschspannung ( (V_{POL,} V_{ER-}) an die Gate-Elektroden von Transistoren mit offenem Gitter der zu löschenden Seite und das Anlegen einer positiven Löschspannung (V_{ER+}) an die Source- oder Drain-Elektroden aller Transistoren mit offenem Gitter des Sektors (S1) des Speichers, der die zu löschende Seite umfasst, einschließt, wobei das Löschen einer Seite das Anlegen einer positiven Hemmungsspannung (V_{INHIB}, V_{PCX}) an die Gate-Elektroden der Transistoren mindestens einer Seite des Speichers, die nicht gelöscht werden soll, umfasst, **dadurch gekennzeichnet, dass** es einen Schritt der Kontrolle von mindestens einer Seite des Speichers einschließt, umfassend ein erstes Lesen der erstellten Seite durch Anlegen einer ersten Lesespannung (V_{READ}) an die Gate-Elektroden der Transistoren der Seite, ein zweites Lesen der erstellten Seite durch Anlegen einer zweiten, zu der ersten Lesespannung unterschiedlichen Lesespannung (V_{VRFY}) an die Gate-Elektroden der Transistoren der Seite, und eine Neuprogrammierung der Transistoren, wenn die beiden Lesungen unterschiedliche Resultate ergeben (W1, W2).

2. Verfahren nach Anspruch 1, bei dem die zweite Lesespannung (V_{VRFY}) größer als die erste Lesespannung (V_{READ}) ist, wobei die erste Lesespannung (V_{READ}) einer normalen Lesespannung entspricht, die während Lesephasen des Speichers verwendet wird, und die Neuprogrammierung von Transistoren erfolgt, wobei als Neuprogrammierungsdaten die Daten verwendet werden, die unter Anwendung der ersten Lesespannung (V_{READ}) gelesen wurden.

3. Verfahren nach einem der Ansprüche 1 und 2, bei dem die Hemmungsspannung (V_{INHIB}, V_{PCX}) geringer als die positive Löschspannung (V_{ER+}) ist.

4. Verfahren nach einem der Ansprüche 1 bis 3, umfassend einen Schritt, der darin besteht, in dem Speicher Schaltungen zur Spannungsanpassung (ADᵢ) vorzusehen, die jeweils am Eingang ein Seitenauswahlsignal (SELᵢ) empfangen und an die Gate-Elektroden der Transistoren der entsprechenden Seite liefern:
- eine positive Spannung (V_{PCX}), wenn das Seitenauswahlsignal einen ersten Wert ("0") entsprechend der Nichtauswahl der Seite aufweist und wenn der Speicher im Löschmodus (ERASE) ist oder wenn das Auswahlsignal einen zweiten Wert ("1") entsprechend der Auswahl der Seite aufweist und der Speicher nicht im Löschmodus ist, oder
- eine Polarisationsspannung (V_{POL}) , die geringer als die positive Spannung (V_{PCX}, V_{INHIB}) ist, wenn das Auswahlsignal den zweiten Wert ("1") aufweist und der Speicher im Löschmodus ist oder wenn das Auswahlsignal den ersten Wert ("0") aufweist und der Speicher nicht im Löschmodus ist.

5. Verfahren nach Anspruch 4, bei dem die Schaltungen zur Spannungsanpassung (ADᵢ) empfangen:
- während des Löschens einer Seite eine Polarisationsspannung (V_{POL}) gleich der negativen Löschspannung (V_{ER-}) und eine positive Spannung (V_{PCX}) gleich der Hemmungsspannung (V_{INHIB}) , und
- während des Lesens eines Wortes im Speicher eine Polarisationsspannung (V_{POL}) gleich dem Massepotential (GND) und eine positive Spannung (V_{PCX}) gleich einer Lesespannung (V_{READ}) .

6. Verfahren nach einem der Ansprüche 1 bis 5, umfassend nach jedem Schreiben einer Seite in einem Sektor des Speichers die Kontrolle von K Seiten des betreffenden Sektors, wobei K unbedingt kleiner als die Seitenzahl des betreffenden Sektors und mindestens gleich 1 ist.

7. Verfahren nach einem der Ansprüche 1 bis 6, bei dem der Kontrollschritt an mindestens einer Seite des Speichers angewandt wird, die sich an einer Adresse im nicht flüchtigen Zähler (CMPT) befindet, der von mindestens einer Reihe von Transistoren mit offenem Gitter gebildet ist.

8. Verfahren nach Anspruch 7, bei dem der Zähler um eine Einheit (SHIFT) nach der Kontrolle von mindestens einer Seite inkrementiert wird, wobei mindestens ein Transistor mit offenem Gitter des Zählers programmiert wird, ohne die anderen Transistoren des Zählers zu löschen, wobei der bei jeder neuen Inkrementierung des Zählers programmierte Transistor der auf den bei der vorhergehenden Inkrementierung programmierten Transistor folgende Transistor in eine Leserichtung des Zählers ist.

9. Verfahren nach einem der Ansprüche 7 und 8, bei dem der Zähler eine Vielzahl von Worten steigenden Ranges umfasst und das Lesen der Adresse von mindestens einer zu kontrollierenden Seite im Zähler die Schritte umfasst, darin bestehend:
- den Zähler Wort für Wort zu lesen, bis ein Wort (c[7:0]) gefunden wird, das ein einem gelöschten Transistor entsprechendes Bit umfasst,
- die Bits mit starkem Gewicht (a'[18:11]) der Adresse der zu kontrollierenden Seite mit Hilfe des Ranges des ersten gefundenen Wortes im Zähler, das ein einem gelöschten Transistor entsprechendes Bit umfasst, zu bestimmen, und
- die Bits mit geringem Gewicht (a'(11:8]) der Adresse der zu kontrollierenden Seite mit Hilfe des Ranges im ersten gefundenen Wort des ersten einem gelöschten Transistor entsprechenden Bits zu bestimmen.

10. Verfahren nach einem der Ansprüche 7 bis 9, bei dem die Transistoren mit offenem Gitter des Zählers in einem ausschließlich dem Zähler gewidmeten Sektor angeordnet sind, so dass Programmierspannungen, die an Transistoren mit offenem Gitter eines anderen Sektors (S1-S8) des Speichers angelegt werden, nicht auf die Transistoren mit offenem Gitter des Zählers zurückwirken.

11. Verfahren nach einem der Ansprüche 1 bis 10, bei dem die Kontrolle einer Seite Wort für Wort erfolgt und die Kontrolle eines Wortes das Lesen des Wortes mit der ersten Lesespannung (V_{READ}), das Lesen des Wortes mit der zweiten Lesespannung (V_{VRFY}) und das Neuprogrammieren von Transistoren umfasst, wenn die beiden Lesungen unterschiedliche Resultate (W1, W2) ergeben.

12. Verfahren nach einem der vorhergehenden Ansprüche, bei dem die positive Löschspannung (V_{ER+}) an die Sourceoder Drain-Elektroden der Transistoren mit offenem Gitter über das Material (1), das den Kanal (CHN) der Transistoren bildet, angelegt wird.

13. Seitenlöschbarer Flash-Speicher (MEM1), umfassend:
- einen Speicherplan (FMA), umfassend eine Vielzahl von Seiten, jeweils umfassend Transistoren mit offenem Gitter, die mit ihren Gate-Elektroden an Wortzeilen (WLᵢ) angeschlossen sind,
- einen Wortzeilendecoder (XDEC1) , der an die Wortzeilen des Speichers angeschlossen ist.
- Mittel, um eine positive Löschspannung (V_{ER+}) an die Source- oder Drain-Elektroden aller Transistoren mit offenem Gitter eines Sektors, der eine zu löschende Seite umfasst, anzulegen,
wobei der Wortzeilendecoder (XDEC1) Mittel (ADᵢ) umfasst, um beim Löschen einer Seite eine negative Löschspannung (V_{POL}, V_{ER-}) an die Gate-Elektroden der Transistoren der zu löschenden Seite anzulegen, wobei eine positive Hemmungsspannung (V_{INHIB}, V_{PCX}) an die Gate-Elektroden von mindestens einer nicht zu löschenden Seite angelegt wird, **dadurch gekennzeichnet, dass** er Mittel (CMPT, SREG, CONVC, DETZ, LT, XDECl, SA, COMP) zur Kontrolle mindestens einer Seite des Speichers umfasst, die derart angeordnet sind, dass sie ein erstes Lesen der Seite durchführen, wobei sie eine erste Lesespannung (V_{READ}) an die Gate-Elektroden der Transistoren der Seite anlegen, dass sie ein zweites Lesen der Seite durchführen, wobei sie eine von der ersten Lesespannung unterschiedliche zweite Lesespannung (V_{VRFY}) an die Gate-Elektroden der Transistoren der Seite anlegen, und dass sie Transistoren der Seite neu programmieren, wenn die beiden Lesungen unterschiedliche Resultate (W1, W2) ergeben.

14. Speicher nach Anspruch 13, bei dem die zweite Lesespannung (V_{VRFY}) größer als die erste Lesespannung (V_{READ}) ist, die erste Lesespannung (V_{READ}) einer normalen Lesespannung entspricht, die während der Lesephasen des Speichers verwendet wird, und die Neuprogrammierung der Transistoren erfolgt, wobei als Neuprogrammierungsdaten die gelesenen Daten verwendet werden, wobei die erste Lesespannung (V_{READ}) angelegt wird.

15. Speicher nach einem der Ansprüche 13 und 14, in dem die Hemmungsspannung (V_{INHIB}, V_{PCX}) , die vom Wortzeilendecoder (XDEC1) geliefert wird, geringer als die positive Löschspannung (V_{ER+}) ist.

16. Speicher nach einem der Ansprüche 13 bis 15, in dem der Wortzeilendecoder (XDEC1) Schaltungen zur Spannungsanpassung. (ADᵢ) umfasst, die am Eingang ein Seitenauswahlsignal (SELᵢ) empfangen und an die Gate-Elektroden der Transistoren der entsprechenden Seite liefern:
- eine positive Spannung (V_{PCX}) , wenn das Seitenauswahlsignal einen ersten Wert ("0") entsprechend der Nichtauswahl der Seite aufweist und wenn der Speicher im Löschmodus (ERASE) ist oder wenn das Auswahlsignal einen zweiten Wert ("1") entsprechend der Auswahl der Seite aufweist und der Speicher nicht im Löschmodus (ERASE) ist, oder
- eine Polarisationsspannung (V_{POL}), die geringer als die positive Spannung (V_{PCX}, V_{INHIB}) ist, wenn das Auswahlsignal den zweiten Wert ("1") aufweist und der Speicher im Löschmodus ist oder wenn das Auswahlsignal den ersten Wert ("0") aufweist und der Speicher nicht im Löschmodus (ERASE) ist.

17. Speicher nach Anspruch 16, umfassend Mittel (PMP, SWP), um an die Schaltungen zur Spannungsanpassung (ADᵢ) zu liefern:
- während des Löschens einer Seite eine Polarisationsspannung (V_{POL}) gleich der negativen Löschspannung (V_{ER-}) und eine positive Spannung (V_{PCX}) gleich der Hemmungsspannung (V_{INHIB}) , und
- während des Lesens eines Wortes im Speicher eine -. Polarisationsspannung (V_{POL}) gleich dem Massepotential (GND) und eine positive Spannung (V_{PCX}) gleich einer Lesespannung (V_{READ}) .

18. Speicher nach Anspruch 17, in dem die Schaltung zur Spannungsanpassung (ADᵢ) eine Ausgangsumkehrstufe (INV2) umfasst, die einerseits die positive Spannung (V_{PCK}, V_{INHIB}) und andererseits die Polarisationsspannung (V_{POL}, V_{ER-}, GND) empfängt, und eine Steuerstufe für die Umkehrstufe umfasst, umfassend eine logische Funktion ODER EXKLUSIV (XOR), die am Eingang das Auswahlsignal (SELᵢ) und ein Signal (ERASE) empfängt, das einen bestimmten Wert während des Löschens einer Seite aufweist.

19. Speicher nach einem der Ansprüche 13 bis 18, in dem die Kontrollmittel derart angeordnet sind, dass nach jedem Schreiben einer Seite in einen Sektor des Speichers K Seiten des betreffenden Sektors kontrolliert werden, wobei K unbedingt kleiner als die Seitenzahl des betreffenden Sektors und mindestens gleich 1 ist.

20. Speicher nach einem der Ansprüche 13 bis 19, in dem die Kontrollmittel umfassen:
- einen nicht flüchtigen Zähler (CMPT), der von mindestens einer Reihe von Transistoren mit offenem Gitter gebildet ist,
- Mittel (SREG, CONVC, DETZ), um in dem Zähler die Adresse von mindestens einer zu kontrollierenden Seite zu lesen, und
- Mittel (SREG, LT) zum Inkrementieren des Zählers nach der Kontrolle von mindestens einer Seite.

21. Speicher nach Anspruch 20, in dem die Mittel zum Lesen der Adresse von mindestens einer zu kontrollierenden Seite umfassen:
- Mittel (CDEC, SA, DETZ, CAC) zum Lesen des Zählers Wort für Wort und zum Suchen eines Wortes (c[7:0]), das ein einem gelöschten Transistor entsprechendes Bit enthält,
- Mittel (CONVX, MUX1) um Bits mit starkem Gewicht (a' [18:11]) der Adresse der zu kontrollierenden Seite mit Hilfe des Ranges des ersten gefundenen Wortes im Zähler, das ein einem gelöschten Transistor entsprechendes Bit umfasst, zu liefern, und
- Mittel (CAC, MUX2) um Bits mit geringem Gewicht (a'[11:8]) der Adresse der zu kontrollierenden Seite mit Hilfe des Ranges im ersten gefundenen Wort des ersten einem gelöschten Transistor entsprechenden Bits zu berechnen.

22. Speicher nach einem der Ansprüche 20 und 21, in dem die Mittel (SREG, LT) zum Inkrementieren des Zählers derart angeordnet sind, dass sie zumindest einen Transistor mit offenem Gitter des Zählers inkrementieren, ohne die anderen Transistoren des Zählers zu löschen, wobei der bei jeder neuen Inkrementierung programmierte Transistor der auf den bei der vorhergehenden Inkrementierung programmierten Transistor folgende Transistor in eine Leserichtung des Zählers ist.

23. Speicher nach einem der Ansprüche 20 bis 22, in dem die Transistoren mit offenem Gitter des Zählers (CMPT) in einem ausschließlich dem Zähler gewidmeten Sektor angeordnet sind, so dass Programmierspannungen, die an Transistoren mit offenem Gitter eines weiteren Sektors LS1-SS) des Speichers angelegt werden, nicht auf die Transistoren mit offenem Gitter des Zählers zurückwirken.

24. Speicher nach einem der Ansprüche 12 bis 23, in dem die Mittel zur Kontrolle mindestens einer Seite derart angeordnet sind, dass sie eine Seite Wort für Wort kontrollieren, wobei die Kontrolle eines Wortes das Lesen des Wortes mit der ersten Lesespannung (V_{READ}) , das Lesen des Wortes mit der zweiten Lesespannung (V_{VRFY}), den Vergleich der Resultate der beiden Lesungen und die Neuprogrammierung der Transistoren des Wortes, wenn die beiden Lesungen unterschiedliche Resultate ergeben, umfasst.

25. Speicher nach einem der Ansprüche 13 bis 24, in dem die positive Löschspannung (V_{ER+}) an die Source- oder Drain-Elektroden der Transistoren mit offenem Gitter mit Hilfe des den Kanal (CHN) der Transistoren bildenden Materials (1) angelegt wird.

## Claims

1. Method for logging data in a FLASH memory comprising at least one sector (S1) , wherein the erasing of a page (Pᵢ) from the memory comprises applying a negative erase voltage (V_{POL}, V_{ER-}) to the gates of the floating-gate transistors of the page to be erased and applying a positive erase voltage (V_{ER+}) to the source or drain electrodes of all the floating-gate transistors of the sector (S1) of the memory comprising the page to be erased, **characterised in that** the erasing of a page comprises applying a positive inhibit voltage (V_{INHIB}, V_{PCX}) to the gates of the transistors of at least one page of the memory that is not to be erased, and **in that** it comprises a step of controlling at least one page of the memory, comprising a first reading of the page by applying a first read voltage (V_{READ}) to the gates of the transistors of the page, a second reading of the page by applying a second read voltage (V_{VRFY}) to the gates of the transistors of the page, and reprogramming transistors if the two readings yield different results (W1, W2).

2. Method according to claim 1, wherein the second read voltage (V_{VRFY}) is higher than the first read voltage (V_{READ}) , the first read voltage (V_{READ}) corresponds to a normal read voltage used during phases of reading the memory, and the transistors are reprogrammed by using the data read by applying the first read voltage (V_{READ}) as reprogramming data.

3. Method according to one of claims 1 and 2, wherein the inhibit voltage (V_{INHIB}, V_{PCX}) is lower than the positive erase voltage (V_{ER+}) .

4. Method according to one of claims 1 to 3, comprising a step of providing voltage adapter circuits (ADᵢ) in the memory, each receiving a page select signal (SELᵢ) at input and delivering to the gates of the transistors of the corresponding page:
- a positive voltage (V_{PCX}) , when the page select signal has a first value ("0") corresponding to the non-selection of the page and the memory is in erase mode (ERASE) or when the select signal has a second value ("1") corresponding to the selection of the page and the memory is not in erase mode, or
- a bias voltage (V_{POL}) lower than the positive voltage (V_{PCX}, V_{INHIB}) , when the select signal has the second value ("1") and the memory is in erase mode or when the select signal has the first value ("0") and the memory is not in erase mode.

5. Method according to claim 4, wherein the voltage adapter circuits (ADᵢ) receive:
- a bias voltage (V_{POL}) equal to the negative erase voltage (V_{ER-}) and a positive voltage (V_{PCX}) equal to the inhibit voltage (V_{INHIB}) during the erasing of a page, and
- a bias voltage (V_{POL}) equal to the ground potential (GND) and a positive voltage (V_{PCX}) equal to a read voltage (V_{READ}) during the reading of a word in the memory.

6. Method according to one of claims 1 to 5 comprising, after each writing of a page in a sector of the memory, controlling K pages of the sector considered, K being strictly lower than the number of pages of the sector considered and at least equal to 1.

7. Method according to one of claims 1 to 6, wherein the control step is applied to at least one page of the memory located at an address read in a non-volatile counter (CMPT) formed by at least one row of floating-gate transistors.

8. Method according to claim 7, wherein the counter is incremented by one unit (SHIFT) after the control of at least one page, by programming at least one floating-gate transistor of the counter without erasing the other transistors of the counter, the transistor programmed upon each new increment of the counter being the transistor following the transistor programmed upon the previous increment, according to a reading direction of the counter.

9. Method according to one of claims 7 and 8, wherein the counter comprises a plurality of words of increasing rank, and the reading in the counter of the address of at least one page to be controlled comprises the steps of:
- reading the counter word by word until a word (c [7:0]) comprising a bit corresponding to an erased transistor is found,
- determining the most significant bits (a'[18:11]) of the address of the page to be controlled using the rank, in the counter, of the first word found comprising a bit corresponding to an erased transistor, and
- determining the least significant bits (a'[11:8]) of the address of the page to be controlled using the rank, in the first word found, of the first bit corresponding to an erased transistor.

10. Method according to one of claims 7 to 9, wherein the floating-gate transistors of the counter are arranged in a sector exclusively dedicated to the counter, such that programming voltages applied to floating-gate transistors of another sector (S1-S8) of the memory are not passed onto the floating-gate transistors of the counter.

11. Method according to one of claims 1 to 10, wherein a page is controlled word by word and the control of a word comprises reading the word with the first read voltage (V_{READ}), reading the word with the second read voltage (V_{VRFY}) , and reprogramming transistors if the two readings yield different results (W1, W2) .

12. Method according to one of the previous claims, wherein the positive erase voltage (V_{ER+}) is applied to the source or drain electrodes of the floating-gate transistors through the material (1) forming the channel (CHN) of the transistors.

13. Page-erasable FLASH memory (MEMl) comprising:
- a memory array (FMA) comprising a plurality of pages each comprising floating-gate transistors connected by their gates to word lines (WLᵢ) ,
- a word line decoder (XDECl) connected to the word lines of the memory,
- means for applying a positive erase voltage (V_{ER+}) to the source or drain electrodes of all the floating-gate transistors of a sector comprising a page to be erased,
**characterised in that** the word line decoder (XDEC1) comprises means (ADᵢ) for applying, when a page is being erased, a negative erase voltage (V_{POL}, V_{ER-}) to the gates of the transistors of the page to be erased, while applying a positive inhibit voltage (V_{INHIB} , V_{PCX}) to the gates of the transistors of at least one page that is not to be erased, and **in that** it comprises means (CMPT, SREG, CONVC, DETZ, LT, XDEC1, SA, COMP) for controlling at least one page of the memory, arranged to carry out a first reading of the page by applying a first read voltage (V_{READ}) to the gates of the transistors of the page, carrying out a second reading of the page by applying a second read voltage (V_{VRFY}) to the gates of the transistors of the page, and reprogramming transistors of the page if the two readings yield different results (W1, W2).

14. Memory according to claim 13, wherein the second read voltage (V_{VRFY}) is higher than the first read voltage (V_{READ}) , the first read voltage (V_{READ}) corresponds to a normal read voltage used during phases of reading the memory, and transistors are reprogrammed by using the data read by applying the first read voltage (V_{READ}) as reprogramming data.

15. Memory according to one of claims 13 and 14, wherein the inhibit voltage (V_{INHIB,} V_{PCX}) delivered by the word line decoder (XDEC1) is lower than the positive erase voltage (V_{ER+}) .

16. Memory according to one of claims 13 to 15, wherein the word line decoder (XDEC1) comprises voltage adapter circuits (ADᵢ) receiving a page select signal (SELᵢ) at input and delivering to the gates of the transistors of the corresponding page:
- a positive voltage (V_{PCX}) , when the select signal has a first value ("0") corresponding to the non-selection of the page and the memory is in erase mode (ERASE) or when the select signal has a second value ("1") corresponding to the selection of the page and the memory is not in erase mode (ERASE), or
- a bias voltage (V_{POL}) lower than the positive voltage (V_{PCX}, V_{INHIB}) , when the select signal has the second value ("1") and the memory is in erase mode (ERASE) or when the select signal has the first value ("0") and the memory is not in erase mode (ERASE).

17. Memory according to claim 16, comprising means (PMP, SWP) for supplying the voltage adapter circuits (ADᵢ) with:
- a bias voltage (V_{POL}) equal to the negative erase voltage (V_{ER-}) and a positive voltage (V_{PCX}) equal to the inhibit voltage (V_{INHIB}) during the erasing of a page, and
- a bias voltage (V_{POL}) equal to the ground potential (GND) and a positive voltage (V_{PCX}) equal to a read voltage (V_{READ}) during the reading of a word in the memory.

18. Memory according to claim 17, wherein the voltage adapter circuit (ADᵢ) comprises an output inverting stage (INV2) receiving firstly the positive voltage (V_{PCX}, V_{INHIB}) and secondly the bias voltage (V_{POL}, V_{ER-}, GND) , and a control stage of the inverting stage comprising an EXCLUSIVE OR logic function (XOR) receiving the select signal (SELᵢ) and a signal (ERASE) having a determined value during the erasing of a page at input.

19. Memory according to one of claims 13 to 18, wherein the control means are arranged for controlling, after each writing of a page in a sector of the memory, K pages of the sector considered, K being strictly lower than the number of pages of the sector considered and at least equal to 1.

20. Memory according to one of claims 13 to 19, wherein the control means comprise:
- a non-volatile counter (CMPT) formed by at least one row of floating-gate transistors,
- means (SREG, CONVC, DETZ) for reading the address of at least one page to be controlled in the counter, and
- means (SREG, LT) for incrementing the counter after the control of at least one page.

21. Memory according to claim 20, wherein the means for reading the address of at least one page to be controlled comprise:
- means (CDEC, SA, DETZ, CAC) for reading the counter word by word and for searching for a word (c [7: 0] ) containing a bit corresponding to an erased transistor,
- means (CONVC, MUXl) for delivering most significant bits (a' [18:11]) of the address of the page to be controlled using the rank, in the counter, of the first word found containing a bit corresponding to an erased transistor, and
- means (CAC, MUX2) for calculating least significant bits (a'[11:8]) of the address of the page to be controlled using the rank, in the first word found, of the first bit corresponding to an erased transistor.

22. Memory according to one of claims 20 and 21, wherein the means (SREG, LT) for incrementing the counter are arranged to program at least one floating-gate transistor of the counter without erasing the other transistors of the counter, the transistor programmed upon each new increment being the transistor following the transistor programmed upon the previous increment, according to a reading direction of the counter.

23. Memory according to one of claims 20 to 22, wherein the floating-gate transistors of the counter (CMPT) are arranged in a sector exclusively dedicated to the counter, such that programming voltages applied to floating-gate transistors of another sector (S1-S8) of the memory are not passed onto the floating-gate transistors of the counter.

24. Memory according to one of claims 13 to 23, wherein the means for controlling at least one page are arranged to control a page word by word, the control of a word comprising reading the word with the first read voltage (V_{READ}) , reading the word with the second read voltage (V_{VRFY}) , comparing the results of the two readings and reprogramming the transistors of the word if the two readings yield different results.

25. Memory according to one of claims 13 to 24, wherein the positive erase voltage (V_{ER+}) is applied to the source or drain electrodes of the floating-gate transistors through the material (1) forming the channel (CHN) of the transistors.
